(19) Europäisches Patentamt
European Patent Office
Office européen des brevets

(11) **EP 4 770 359 A1**

(12) **EUROPEAN PATENT APPLICATION**

(43) Date of publication:
**01.07.2026 Bulletin 2026/27**

(21) Application number: **25217507.0**

(22) Date of filing: **20.11.2025**

(51) International Patent Classification (IPC):
**H10H 29/39** (2025.01)    **H10H 29/41** (2025.01)

(52) Cooperative Patent Classification (CPC):
**H10H 29/39; H10H 29/41;** H10H 29/842

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.12.2024 CN 202411918383**

(71) Applicant: **Tianma Advanced Display Technology
Institute
(Xiamen) Co., Ltd.
361101 Xiamen (CN)**

(72) Inventors:
• JIA, Zhenyu
 361101 Xiamen, Fujian (CN)
• MENG, Fanqing
 361101 Xiamen, Fujian (CN)
• XI, Kerui
 361101 Xiamen, Fujian (CN)

(74) Representative: **Germain Maureau
12, rue Boileau
69006 Lyon (FR)**

(54) **DISPLAY PANEL AND DISPLAY DEVICE**

(57) A display panel and a display device are provided. The display panel includes a substrate; a driving array layer located on one side of the substrate; a first planarization layer located on a side of the driving array layer away from the substrate; a first conductive layer located on a side of the first planarization layer away from the substrate and including a plurality of electrodes; and a second planarization layer located a side of the first conductive layer away from the substrate and including a plurality of first openings running through the second planarization layer. In a direction perpendicular to a plane in which the substrate is located, a first opening of the plurality of first openings exposes at least a portion of an electrode of the plurality of electrodes.

**FIG. 2**

EP 4 770 359 A1

## Description

TECHNICAL FIELD

The present disclosure generally relates to the field of display technologies and, more particularly, relates to a display panel and a display device.

BACKGROUND

Display devices have a wide range of application scenarios in life, such as mobile phones, tablet computers and other electronic devices. Display panels are important parts of display devices.

In the display panels, display substrates generally adopt a multi-metal layer stacking structure, and the top metal layer needs to be patterned to form a conductive structure with different functions. However, limited by the requirement of uniformity, the thickness of the top metal layer of the display substrate is difficult to be thinned, so that the top layer of the display substrate has a graphic obvious concave-convex structure, and it is difficult to achieve a high degree of flatness on the surface, which is easy to affect the performance of the display substrate, and then affect the display quality.

Therefore, providing a display panel and a display device that can improve the flatness of the substrate and ensure the display effect is a technical problem that needs to be solved by technicians in this field. The present disclosed display panels and display devices are direct to solve such problems and other problems in the arts.

SUMMARY

One aspect of the present disclosure provides a display panel. The display panel comprises: a substrate; a driving array layer located on a side of the substrate; a first planarization layer located on a side of the driving array layer away from the substrate; a first conductive layer located on a side of the first planarization layer away from the substrate, wherein the first conductive layer comprises a plurality of electrodes; and a second planarization layer located a side of the first conductive layer away from the substrate, where the second planarization layer comprises a plurality of first openings running through the second planarization layer; where in a direction perpendicular to a first plane in which the substrate is located , a first opening of the plurality of first openings exposes at least a portion of an electrode of the plurality of electrodes.

Another aspect of the present disclosure includes a display device. The display device comprises a display panel. The display panel comprises: a substrate; a driving array layer located on a side of the substrate; a first planarization layer located on a side of the driving array layer away from the substrate; a first conductive layer located on a side of the first planarization layer away from the substrate, wherein the first conductive layer comprises a plurality of electrodes; and a second planarization layer located a side of the first conductive layer away from the substrate, where the second planarization layer comprises a plurality of first openings running through the second planarization layer; where in a direction perpendicular to a first plane in which the substrate is located , a first opening of the plurality of first openings exposes at least a portion of an electrode of the plurality of electrodes.

Other aspects of the present disclosure can be understood by those skilled in the art in light of the description, the claims, and the drawings of the present disclosure.

BRIEF DESCRIPTION OF THE DRAWINGS

To illustrate the technical solutions in the embodiments of the present disclosure more clearly, the following briefly introduces the accompanying drawings used in the description of the embodiments. Obviously, the accompanying drawings in the following description are only some embodiments of the present disclosure, for those of ordinary skill in the art, other drawings can also be obtained from these drawings without creative effort.

FIG. 1 illustrates a top view of an exemplary display panel according to various embodiments of the present disclosure;

FIG. 2 illustrates A-A'-sectional view in FIG. 1;

FIG. 3 illustrates a top view of a portion of an exemplary display panel according to various embodiments of the present disclosure;

FIG. 4 illustrates another A-A'-sectional view in FIG.1;

FIG. 5 illustrates another A-A'-sectional view in FIG. 1;

FIG. 6 illustrates another A-A'-sectional view in FIG. 1;

FIG. 7 illustrates a top view of the first opening and the second opening and the electrode in FIG. 6;

FIG. 8 illustrates a C-C'-sectional view in FIG. 1;

FIG. 9 illustrates a top view of the first opening and the second opening and the electrode in FIG. 8;

FIG. 10 illustrates another C-C'-sectional view in FIG. 1;

FIG. 11 illustrates another A-A'-sectional view in FIG. 1;

FIG. 12 illustrates another C-C'-sectional view in FIG. 1;

FIG. 13 illustrates a top view of another exemplary display panel according to various embodiments of the present disclosure;

FIG. 14 illustrates a partial zoomed-in view of the J2 area in FIG. 13;

FIG. 15 illustrates another partial zoomed-in view of the J2 area in FIG. 13;

FIG. 16 illustrates another partial zoomed-in view of the J2 area in FIG. 13;

FIG. 17 illustrates a portion of the first conductive layer in FIG. 1 and FIG. 13;

FIG. 18 illustrates another C-C'-sectional view in FIG. 1;

FIG. 19 illustrates a top view of the first opening and the second opening and the electrode in FIG. 18;

FIG. 20 illustrates another partial zoomed-in view of the J2 area in FIG. 13;

FIG. 21 illustrates another partial zoomed-in view of the J2 area in FIG. 13;

FIG. 22 illustrates another A-A'-sectional view in FIG. 1;

FIG. 23 illustrates another A-A'-sectional view in FIG. 1;

FIG. 24 illustrates another A-A'-sectional view in FIG. 1;

FIG. 25 illustrates another A-A'-sectional view in FIG. 1;

FIG. 26 illustrates a top view of another exemplary display panel according to various embodiments of the present disclosure;

FIG. 27 illustrates a D-D'-sectional view in FIG. 26;

FIG. 28 illustrates another D-D'-sectional view in FIG. 26;

FIG. 29 illustrates another D-D'-sectional view in FIG. 26;

FIG. 30 illustrates an F-F'-sectional view in FIG. 26;

FIG. 31 illustrates a top view of another exemplary display panel according to various embodiments of the present disclosure;

FIG. 32 illustrates an E-E'-sectional view in FIG. 31;

FIG. 33 illustrates another D-D'-sectional view in FIG. 26;

FIG. 34 illustrates another D-D'-sectional view in FIG. 26;

FIG. 35 illustrates another D-D'-sectional view in FIG. 26;

FIG. 36 illustrates a partial zoomed-in view of the J3 area in FIG. 26;

FIG. 37 illustrates another partial zoomed-in view of the J3 area in FIG. 26;

FIG. 38 illustrates another D-D'-sectional view in FIG. 26;

FIG. 39 illustrates another D-D'-sectional view in FIG. 26; and

FIG. 40 illustrates an exemplary display device according to various embodiments of the present disclosure.

DETAILED DESCRIPTION

To more clearly understand the above-mentioned purposes, features and advantages of the present disclosure, the scheme of the present disclosure will be further described below. It should be noted that the embodiments of the present disclosure and the features in the embodiments can be combined with each other without conflict.

In the following description, many specific details are explained to facilitate a full understanding of the present disclosure, but the present disclosure can also be implemented in other ways different from those described herein. Obviously, the embodiments in the specification are only part of the embodiments of the present disclosure, not all of them.

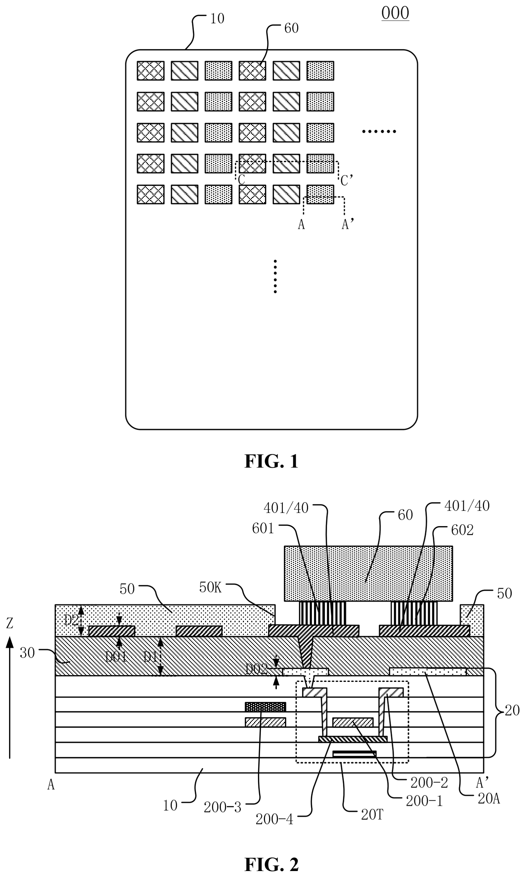

The present disclosure provides a display panel and a display device. FIG. 1 is a schematic diagram of a top view of an exemplary display panel provided by one embodiment of the present disclosure. FIG. 2 is a schematic diagram of an A-A'-sectional view in FIG. 1.

As shown in FIGS. 1-2, a display panel 000 may include a substrate 10, a driving array layer 20 located on one side of substrate 10, a first planarization layer 30 located on the side of the driving array layer 20 away from the substrate 10, and a first conductive layer 40 located on the side of first planarization layer 30 away from substrate 10. The first conductive layer 40 may include a plurality of electrodes 401.

The display panel may also include a second planarization layer 50 located on the side of the first conductive layer 40 away from the substrate 10. The second planarization layer 50 may include a plurality of first openings 50K. The first openings 50K may pass through the second planarization layer 50. In a direction Z perpendicular to the plane where substrate 10 is located, the first opening 50K may expose at least a portion of the electrode 401.

Specifically, the display panel 000 provided in the embodiments of the present disclosure may be a micro light-emitting diode (micro-LED) display panel or a sub-millimeter light-emitting diode (mini-LED) display panel. The layer structure of the display panel 000 may include a substrate 10. The substrate 10 may be used as a carrier substrate of the display panel 000, and may be used to manufacture and set the remaining structures of the display panel 000 on the substrate 10. For example, in one embodiment, the substrate 10 may be used to manufacture the layer structures such as the driving array layer 20, the first planarization layer 30, the first conductive layer 40, and the second planarization layer 50 located on one side of the substrate 10. The first planarization layer 30 may be located on the side of the driving array layer 20 away from the substrate 10. The first planarization layer 30 may be an organic film layer. The driving array layer 20 may be generally used to set circuits and signal line structures such as thin-film transistors 20T that drive the light-emitting device to emit light. Therefore, the surface of the driving array layer 20 away from the substrate 10 may be flattened by the first planarization layer 30. It can be understood that the driving array layer 20 of this embodiment may be a combination of multiple metal conductive layers and multiple inorganic layers, or a combination of multiple metal conductive layers and multiple inorganic layers or organic layers. This embodiment does not limit this. When it is implemented, the film layer of the driving array layer 20 may be set according to the actual design requirements of the display panel. As shown in FIG. 2, the driving array layer 20 may include the conductive layers, such as a gate metal layer 200-1 where the gate of the thin-film transistor 20T is located, a source and drain metal layer 200-2 where the source and drain of the thin-film transistor 20T are located, a capacitor metal layer 200-3 where the capacitor plates are located, and a semiconductor layer 200-4 where the active area of the thin-film transistor 20T is located. The driving array layer 20 may also include inorganic layers or organic layers between adjacent conductive layers. FIG. 2 is only one of the examples, when it is implemented, the film layer structure of the driving array layer 20 may include any other suitable structures without limitations.

The first conductive layer 40 of the present disclosure may be located on the side of the first planarization layer 30 away from the substrate 10, and the first conductive layer 40 may include a plurality of electrodes 401. It is understandable that in this embodiment, the plurality of electrodes 401 may be located outside the frame of the display panel 000, for transmitting the driving signals provided by the subsequently bonded driving chip or flexible circuit board, or the plurality of electrodes 401 may also be located in the non-frame area of the display panel 000 (which may be understood as the display area or light-emitting area of the display panel 000), that is, the plurality of electrodes 401 may be bonding electrodes, which may be used to transmit the signal driving the light-emitting device to the subsequently bonded light-emitting device after the light-emitting device is bonded to the electrodes 401. This embodiment is schematically explained by taking the electrode 401 as the bonding electrode as an example. It may be understandable that the driving array layer 20 in this embodiment may include a structure of multiple conductive film layers and multiple insulation layers, and the driving array layer 20 may be understood as a film layer for making a driving circuit structure for driving the light-emitting device to emit light. The first planarization layer 30 of this embodiment may be located on the side of the first conductive layer 40 facing the substrate 10, so that before the first conductive layer 40 is made, the first planarization layer 30 may flatten the surface of the driving array layer 20 away from the substrate 10, and the surface of the substrate 10 may be as flat as possible. The first conductive layer 40 may be formed on the first planarization layer 30 with relatively high flatness, which may effectively ensure the flatness of the electrode 401, and facilitate the improvement of the bonding stability of the light-emitting device subsequently bonded to the electrode 401.

In one embodiment, the first conductive layer 40 may be made of metal material or transparent conductive material, which is not limited, and it is only required that the first conductive layer 40 has the conductive properties.

In one embodiment, as shown in FIG. 2, the driving array layer 20 may be used to form the circuit structures such as the thin-film transistors 20T that drive the light-emitting device to emit light, and the source or drain of the thin-film transistor 20T may be electrically connected to the anode pin 601 of the light-emitting device 60 through the electrode 401, and the cathode pin 602 of the light-emitting device 60 may be electrically connected to the cathode signal line (not shown in the figure) in the display panel 000 through the electrode 401. The driving array layer 20 may also include a plurality of conductive signal lines (such as scanning signal lines, data signal lines, or power signal lines, etc.) to transmit the driving signal to each light-emitting device 60 and drive the normal light-emitting display effect of the light-emitting device 60 (different filling patterns represent light-emitting devices of different colors in FIG. 1). The light-emitting device 60 of this embodiment may be a light-emitting device such as a micro-LED or a mini-LED. In specific implementations, the light-emitting device 60 may be transferred to a substrate on which the driving array layer 20, the first conductive layer 40 and other film layers have been completed by the mass transfer technology, so that the anode pin 601 and the cathode pin 602 of the light-emitting device 60 may be respectively electrically connected to the electrodes 401 of the first conductive layer 40 on the substrate 10, thereby realizing the driving circuit structure of the driving array layer 20 to drive the light-emitting device 60 to emit light and realize the display function.

In one embodiment, the packaging form of the light-emitting device 60 in the display panel 000 of this embodiment may be a horizontal light-emitting chip. In specific implementation, the packaging form of the light-emitting device 60 may also be a vertical light-emitting chip. This embodiment does not limit this. FIG. 2 of this embodiment only takes the packaging form of the light-emitting device 60 as a horizontal light-emitting chip as an example.

In one embodiment, the light-emitting device 60 may be bonded and electrically connected by setting a conductive structure such as solder or eutectic layer between the electrodes 401 and the anode pin 601 and the cathode pin 602 of the light-emitting device 60 (not shown in the figure). When the light-emitting device 60 is transferred, the cathode pin 602 and the anode pin 601 of the light-emitting device 60 may be aligned with the electrode 401 on the display panel through a micro-stamp, and the conductive structure such as solder or eutectic layer may be pressed by the downward pressing action of the micro-stamp, thereby realizing the bonding and electrical connection between the light-emitting device 60 and the electrodes 401. It can be understood that the eutectic layer may be made of a high melting point eutectic material, such as a eutectic material of solder and silver or gold.

It can be understood that the first conductive layer 40 of this embodiment may include not only the plurality of electrodes 401, but also other patterned conductive structures, such as signal routing, a plate structure of a capacitor, etc. Therefore, after the first conductive layer 40 is patterned, its surface away from the substrate 10 may have a relatively obvious concave-convex structure.

In one embodiment, a second planarization layer 50 may also be provided on the side of the patterned first conductive layer 40 away from the substrate 10. The material of the second planarization layer 50 may be the same as that of the first planarization layer 30, that is, the second planarization layer 50 may be an organic film layer to flatten the surface of the first conductive layer 40 away from the substrate 10, so that the surface of the patterned first conductive layer 40 may be covered by the second planarization layer 50 of organic material, which may play a role in flattening the surface of the first conductive layer 40, that is, a large number of concave-convex structures presented by the patterned first conductive layer 40 may be flattened by the second planarization layer 50, which may improve the flatness of the substrate and may be conducive to improving the performance of the substrate and the display effect. The second planarization layer 50 of this embodiment may include a plurality of first openings 50K, and the first openings 50K may pass through the second planarization layer 50. In the direction Z perpendicular to the plane in which the substrate 10 is located, the first opening 50K may expose at least a portion of the electrode 401, so as to facilitate the subsequent bonding of the light-emitting device 60 with the electrode 401 in the first opening 50K. In one embodiment, the second planarization layer 50 may be arranged on the side of the first conductive layer 40 away from the substrate 10. The high flatness performance of the second planarization layer 50 may improve the flatness problem of the substrate, ensure the reliability of the substrate performance, and enhance the display effect.

In one embodiment, to ensure the flattening effect of the second planarization layer 50, the thickness D2 of the second planarization layer 50 in the direction Z perpendicular to the plane in which the substrate 10 is located may be set to a range of approximately 0.5um-3.5um, so as to avoid the second planarization layer 50 being too thin and the flatness performance cannot be guaranteed, and also to avoid the second planarization layer 50 being too thick due to the thickness of the second planarization layer 50, which may affect the subsequent bonding of the light-emitting device with the electrode 401. Therefore, the thickness D2 of the second planarization layer 50 in the direction Z perpendicular to the plane in which the substrate 10 is located may be set to be in the range of approximately 0.5um-3.5um, which may ensure the flatness of the second planarization layer 50 while ensuring that the setting of the second planarization layer 50 does not affect the subsequent bonding effect of the light-emitting device and the electrodes 401.

It should be noted that the figure of this embodiment only illustrates the structure of the display panel. In the specific implementation, the structure of the display panel is not limited, and may also include other structures that can realize the display function. Details may be referred to the structure of the mini-LED or micro-LED display panel in the relevant technology for understanding, and this embodiment will not be repeated here.

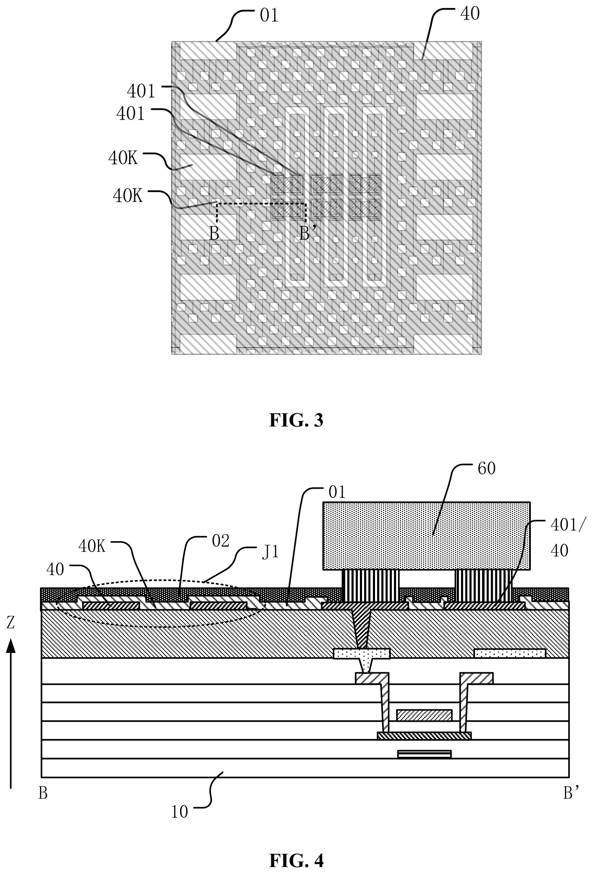

FIG. 3 is a schematic diagram of a top view of a portion of an exemplary display panel provided by an embodiment of the present disclosure, and FIG. 4 is a schematic diagram of a B-B'-sectional view in FIG. 3 (to clearly illustrate the top view of the portion of the display panel, the ink encapsulation layer is not illustrated in FIG. 3). In the display panel 000 shown in FIG. 4, the electrode 401 of the first conductive layer 40 may be mainly used to supply power to the cathode pin of the corresponding light-emitting device through the electrode 401 and to supply power to the anode pin of the corresponding light-emitting device through the electrode 401. The first conductive layer 40 may generally include a large number of through holes 40K to prevent the peeling of the surface layer in the process. The presence of the through holes 40K may make the surface of the patterned first conductive layer 40 present more concave-convex structures. In FIG. 4, on the first conductive layer 40, an inorganic dielectric layer 01 such as a PV layer may be used to protect the patterned first conductive layer 40, and the light-emitting device 60 may be bonded to the electrode 401 through a giant transfer process, and then the ink encapsulation may be performed, that is, the ink encapsulation layer 02 may be formed on the side of the inorganic dielectric layer 01 away from the substrate 10. The ink encapsulation may reduce the reflection of ambient light on the display panel, which may play a role in reducing reflection and avoiding color crosstalk between adjacent light-emitting devices. However, the inorganic dielectric layer 01 may be generally thin and may have the limited flattening ability, resulting in the presence of a graphic concave-convex structure on the upper surface of the substrate (as shown in the dotted circle J1 in FIG. 4), that is, it may be difficult to achieve a high degree of flatness on the upper surface of the substrate 10. When the substrate 10 is encapsulated with ink, this concave-convex structure may affect the diffusion speed and coverage of the ink during encapsulation, thereby reducing the reliability of the encapsulation.

Therefore, in the display panel provided in FIG. 3 and FIG. 4, the patterned first conductive layer presents a large number of concave-convex structures. When the display panel is encapsulated with ink, the large number of concave-convex structures presented by the patterned first conductive layer will affect the diffusion speed and covering ability of the ink during the ink encapsulation, affect the ink encapsulation process on the surface of the substrate, and then affect the ink encapsulation reliability, which is likely to cause the display effect to be not as expected. Although the inorganic dielectric layer is used to cover the patterned metal layer on the top of the display substrate as shown in FIG. 4, the thickness of the inorganic dielectric layer is relatively thin, and its flattening effect is limited.

Therefore, the second planarization layer 50 provided in this disclosure may be located on the side of the patterned first conductive layer 40 away from the substrate 10. The second planarization layer 50 may be an organic film layer to flatten the surface of the first conductive layer 40 away from the substrate 10, so that the surface of the patterned first conductive layer 40 may be covered by the second planarization layer 50 of organic material, which may play a role in flattening the surface of the first conductive layer 40. The high flatness performance of the second planarization layer 50 may improve the flatness problem of the substrate. Since a surface with high flatness may be conducive to improving the diffusion speed and coverage of ink, setting the second planarization layer 50 may improve the quality of subsequent ink encapsulation on the side away from the substrate 10, ensure the reliability of subsequent substrate ink encapsulation, and improve the display effect.

In some embodiments, referring to FIGS. 1-2, in the direction Z perpendicular to the plane in which the substrate 10 is located, the thickness D2 of the second planarization layer 50 may be less than the thickness D1 of the first planarization layer 30, and the thickness D2 of the second planarization layer 50 may be greater than the thickness D01 of the first conductive layer 40.

This embodiment explains that, in the direction Z perpendicular to the plane in which the substrate 10 is located, the thickness D2 of the second flattening layer 50 may be less than the thickness D1 of the first planarization layer 30. Because the first planarization layer 30 may be used to flatten the surface of the driving array layer 20 away from the substrate 10, the thickness D1 of the first planarization layer 30 may be set greater to ensure the flatness of the side of the driving array layer 20 away from the substrate 10. The thickness D2 of the second planarization layer 50 may be used to flatten the surface of the first conductive layer 40 away from the substrate 10, so that the surface of the patterned first conductive layer 40 may be covered by the second planarization layer 50 of organic material, which may play a role in flattening the surface of the first conductive layer 40. However, the first opening 50K of the second planarization layer 50 may expose at least a portion of the electrode 401. The light-emitting device 60 may be subsequently bonded to the electrode 401 in the first opening 50K. To avoid the thickness D2 of the second planarization layer 50 affecting the transfer and bonding process of the light-emitting device 60, the thickness D2 of the second planarization layer 50 should not be too thick, that is, the thickness D1 of the second planarization layer 50 may be less than the thickness D1 of the first planarization layer 30, so that the second planarization layer 50 may improve the flatness of the substrate 10 while ensuring the subsequent transfer and bonding process of the light-emitting device 60 when it is bonded.

In one embodiment, the thickness of the first planarization layer 30 is D1, the thickness of the second planarization layer 50 is D2, 1/2D1 <D2<4/5D1, and the thickness of the second planarization layer 50 may be set between 1/2 of the thickness D1 of the first planarization layer 30 and 4/5 of the thickness D1 of the first planarization layer 30, so as to avoid the second planarization layer 50 being too thin and the flatness performance not being guaranteed, and also avoid the second planarization layer 50 being too thick due to the thickness being too high, which may affect the subsequent bonding of the light-emitting device and the electrode 401. Therefore, the flattening effect of the second planarization layer 50 may be ensured, and the setting of the second planarization layer 50 may be ensured not to affect the subsequent bonding effect of the light-emitting device 60 and the electrode 401.

In one embodiment, the thickness D2 of the second planarization layer 50 may be set to be greater than the thickness D01 of the first conductive layer 40, so that when the second planarization layer 50 is formed on the side of the first conductive layer 40 away from the substrate 10, the second planarization layer 50 may better cover the patterned first conductive layer 40, thereby ensuring the flatness effect on the first conductive layer 40.

In some embodiments, referring to FIGS. 1-2, the display panel 000 may also include a second conductive layer 20A. The second conductive layer 20A may be a conductive layer in the driving array layer 20. The second conductive layer 20A may be located on the side of the first planarization layer 30 adjacent to the substrate 10.

In one embodiment, in the direction Z perpendicular to the plane in which the substrate 10 is located, the thickness D02 of the second conductive layer 20A may be less than the thickness D01 of the first conductive layer 40.

This embodiment explains that the driving array layer 20 may include a patterned second conductive layer 20A, and the second conductive layer 20A may be understood as a conductive layer in the driving array layer 20 that is closest to the first conductive layer 40. The second conductive layer 20A may be located on the side of the first planarization layer 30 adjacent to the substrate 10. The first planarization layer 30 may be used to flatten the patterned first conductive layer 40, and may play the role of flattening the surface of the driving array layer 20 away from the substrate 10. The first conductive layer 40 may be formed on the first planarization layer 30 with high flatness, which may effectively ensure the flatness of the electrode 401, and facilitate the improvement of the bonding stability of the light-emitting device 60 subsequently bonded to the electrode 401. Because the thickness D1 of the first planarization layer 30 may be greater than the thickness of the second planarization layer 50, and the thickness D02 of the second conductive layer 20A may be less than the thickness D01 of the first conductive layer 40, the second conductive layer 20A with a smaller thickness may be flattened by the first planarization layer 30 with a larger thickness, and the first conductive layer 40 with a larger thickness may need to be flattened by the second planarization layer 50 with a smaller thickness, so as to ensure that the second planarization layer 50 may have a flattening effect, and at the same time, it may ensure that the setting of the second planarization layer 50 does not affect the subsequent bonding effect of the light-emitting device and the electrode 401.

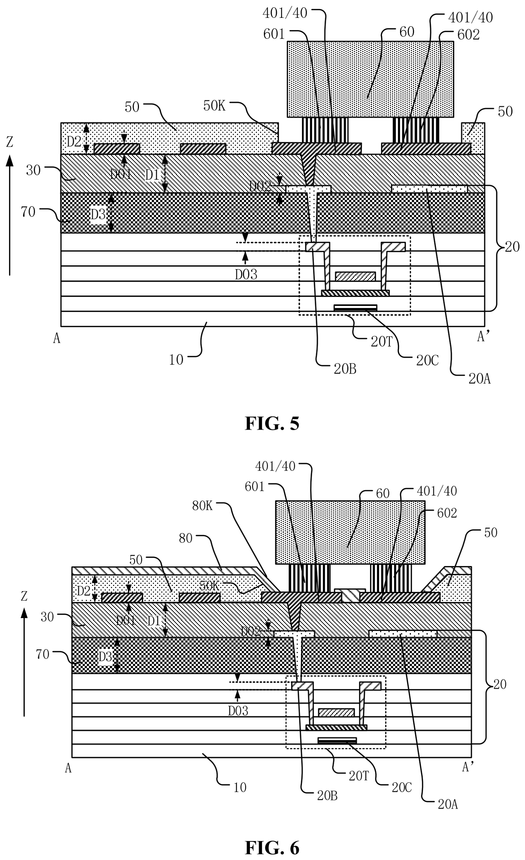

FIG. 5 is another A-A'-sectional view in FIG. 1. As shown in FIG. 1 and FIG. 5, the display panel 000 may further include a third planarization layer 70. The third planarization layer 70 may be located on the side of the first planarization layer 30 adjacent to the substrate 10. The thickness D3 of the third planarization layer 70 may be greater than the thickness D2 of the second planarization layer 50.

The driving array layer 20 may further include a fourth conductive layer 20B. The fourth conductive layer 20B may be located on the side of the second conductive layer 20A adjacent to the substrate 10. If the second conductive layer 20A is used to form driving signal lines such as power signal lines, the fourth conductive layer 20B may be used to form structures such as the source and drain of the thin-film transistor 20T, and the second conductive layer 20A may also be used to form structures such as the conductive portion of the drain of the thin-film transistor 20T and the electrode 401. The third planarization layer 70 may be located on the side of the first planarization layer 30 adjacent to the substrate 10. The third planarization layer 70 may be located on the side of the fourth conductive layer 20B away from the substrate 10, and the third planarization layer 70 may play the role of flattening the patterned fourth conductive layer 20B. The thickness D3 of the third planarization layer 70 in this embodiment may be greater than the thickness D2 of the second planarization layer 50 to ensure the flatness of the film layer by the third planarization layer 70.

In another embodiment, the thickness D03 of the fourth conductive layer 20B may be less than the thickness D01 of the first conductive layer 40. In the first conductive layer 40 and the fourth conductive layer 20B, the fourth conductive layer 20B with a smaller thickness may be flattened with the third planarization layer 70 with a larger thickness, and the first conductive layer 40 with a larger thickness may need to use the second planarization layer 50 with a smaller thickness to flat, so as to ensure that the second planarization layer 50 may have a flattening effect while ensuring that the second planarization layer 50 does not affect the subsequent bonding effect between the light-emitting device and the electrode 401.

In one embodiment, the driving array layer 20 of the display panel 000 may also include a fifth conductive layer 20C. The fifth conductive layer 20C may be located on the side of the semiconductor layer where the active area of the thin-film transistor 20T is located facing the substrate 10, and the fifth conductive layer 20C may be used for forming the bottom gate of the thin-film transistor 20T. If the driving circuit of the display panel 000 (such as a pixel circuit or other display driving circuit) includes a dual-gate transistor, the bottom gate of the thin-film transistor 20T may be located in the fifth conductive layer 20C. The fifth conductive layer 20C where the bottom gate of the thin film transistor 20T is located may also be used as a light-shielding layer to shield the active area of the thin-film transistor 20T, so as to prevent the light on one side of the substrate 10 from shining on the active area to generate carriers and affect the off-state current characteristics of the thin-film transistor 20T, which may be conducive to ensuring the driving effect of the thin-film transistor 20T in the driving circuit and ensuring the display quality.

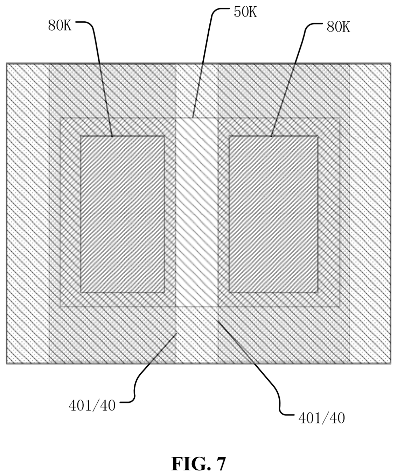

FIG. 6 illustrates another A-A'-sectional view in FIG. 1, and FIG. 7 illustrates a top view of the first opening, the second opening and the electrode in FIG. 6 (it can be understood that in order to clearly illustrate the positional relationship between the first opening and the second opening and the electrode in this embodiment, transparency is filled in FIG. 7). As shown in FIGS. 6-7, in some embodiments, the display panel 000 may also include a first passivation layer 80. The first passivation layer 80 may be located on the side of the second planarization layer 50 away from the substrate 10.

The first passivation layer 80 may include a plurality of second openings 80K. The orthographic projection of the second opening 80K on the substrate 10 may be located within the orthographic projection range of the first opening 50K on the substrate 10. At a periphery of the first opening 50K, the second planarization layer 50 may at least cover a portion of the electrode 401 in a direction perpendicular to the plane in which the substrate 10 is located. At a periphery of the second opening 80K, the first passivation layer 80 may cover the second planarization layer 50 in a direction perpendicular to the plane in which the substrate 10 is located.

This embodiment explains that the film structure of the display panel 000 may also include a first passivation layer 80 located on the side of the second planarization layer 50 away from the substrate 10. The first passivation layer 80 may be an inorganic film layer. The first passivation layer 80 may be used to protect the film layer of the display panel 000, especially to protect the second planarization layer 50 of the organic material, and may have a protective effect of isolating water and oxygen corrosion. In this embodiment, the first passivation layer 80 may include a plurality of second openings 80K. The orthographic projection of the second opening 80K on the substrate 10 may be located within the orthographic projection range of the first opening 50K on the substrate 10, that is, the orthographic projection area of the second opening 80K on the substrate 10 may be smaller than the orthographic projection area of the first opening 50K on the substrate 10, so that along the direction at a periphery of the second opening 80K (such as the second opening 80K is square, this direction refers to around the square edge; if the second opening 80K is circular, this direction refers to around the circular edge), the first passivation layer 80 may cover the second planarization layer 50 in a direction perpendicular to the plane in which the substrate 10 is located, and the second opening 80K may be used to expose at least a portion of the electrode 401, so that the light-emitting device 60 may be subsequently bonded to the electrode 401 in the overlapping first opening 50K and second opening 80K. The orthographic projection of the second opening 80K on the substrate 10 may be located within the orthographic projection range of the first opening 50K on the substrate 10, so that the first passivation layer 80 may completely cover and protect the second planarization layer 50, thereby improving the effect of isolating the substrate 10 from water and oxygen corrosion.

In one embodiment, as shown in FIG. 6, the second opening 80K formed in the first passivation layer 80 and the first opening 50K formed in the second planarization layer 50 may have sloped sidewalls, which may be beneficial to improve the leveling performance of the ink when the ink is subsequently packaged on the side of the first passivation layer 80 away from the substrate 10, and ensure the reliability of the ink packaging.

The present embodiment further provides a second planarization layer 50 in a direction at a periphery of the first opening 50K (if the first opening 50K is square, this direction may refer to the direction around the edge of the square; if the first opening 50K is circular, this direction may refer to the direction around the edge of the circular; and the first opening 50K and the second opening 80K may have the same orthographic projection shape on the plane in which the substrate 10 is located), and the second planarization layer 50 may at least cover a portion of the electrode 401 in a direction perpendicular to the plane in which the substrate 10 is located, that is, although the second planarization layer 50 is provided with a first opening 50K that passes through the thickness of the second planarization layer 50 to expose a portion of the electrode 401, the second planarization layer 50 may at least cover a portion of the electrode 401 in a direction perpendicular to the plane in which the substrate 10 is located (as shown in FIG. 6, at least the edge area outside the electrode 401 is covered), so as to cover and protect the edge area of the electrode 401.

In one embodiment, a first passivation layer 80 may be provided on the side of the second planarization layer 50 away from the substrate 10, and a portion of the electrode 401 may be exposed by overlapping the orthographic projection of the first opening 50K of the second planarization layer 50 on the substrate 10 and the orthographic projection of the second opening 80K of the first passivation layer 80 on the substrate 10, so as to facilitate the subsequent bonding of the light-emitting device 60 to the electrode 401. The ink encapsulation process may be performed after the light-emitting device 60 is bonded to the electrode 401. In this embodiment, the surface of the first passivation layer 80 away from the substrate 10 may need to be set to be lower than the surface of the light-emitting device 60 away from the substrate 10, that is, after the second planarization layer 50 and the first passivation layer 80 are formed on the first conductive layer 40 where the electrode 401 is located, the thickness of the two should not be too large, so as to avoid the surface of the first passivation layer 80 away from the substrate 10 being too high when the light-emitting device 60 is subsequently transferred by the giant transfer process, which may affect the giant transfer and bonding process. In one embodiment, after the light-emitting device 60 is bonded to the electrode 401 exposed by the first opening 50K and the second opening 80K, the surface of the light-emitting device 60 away from the substrate 10 may need to be higher than the surface of the first passivation layer 80 away from the substrate 10, so as to avoid the first passivation layer 80 and the second planarization layer 50 being too high after stacking and affecting the process yield, which may be beneficial to improving the process yield of the entire display panel 000.

It can be understood that in FIGS. 6-7 of this embodiment, the configuration that the first opening 50K of the second planarization layer 50 corresponds to the two electrodes 401 of a light-emitting device 60 is used as an example for illustration, that is, a first opening 50K may expose the bonding position of a light-emitting device 60, and the second opening 80K of the first passivation layer 80 may need to expose the electrode 401 and at least cover the edge area of the two electrodes 401. Therefore, the two electrodes 401 of the light-emitting device 60 may need to correspond to the two second openings 80K of the first passivation layer 80 respectively, so that the partial area between the two electrodes 401 of the light-emitting device 60 may be covered and protected by the first passivation layer 80.

In one embodiment, as shown in FIGS. 1-2 and FIGS. 5-6, the first planarization layer 30 may be located on the side of the driving array layer 20 away from the substrate 10, and the first planarization layer 30 may be used to flatten the surface of the driving array layer 20 away from the substrate 10, so that the first conductive layer 40 formed on the first planarization layer 30 may ensure high flatness as much as possible. The second planarization layer 50 may be located on the side of the first conductive layer 40 away from the substrate 10. Since the second planarization layer 50 covers the electrode 401 of the patterned first conductive layer 40 and electrode 401 is located on a surface of the first planarization layer 30, the second planarization layer 40 may be in direct contact with at least a part of the surface of the first planarization layer 40. In an embodiment, the second planarization layer 50 and the first planarization layer 30 may be in direct contact at a position having no electrode 401, that is, there may be no other film layer between the second planarization layer 50 and the first planarization layer 30 except the first conductive layer 40. Thus, it facilitates the effect that the concave-convex structure presented by the patterned first conductive layer 40 may be flattened by the second planarization layer 50, and it may also avoid the existence of other film layers between the second planarization layer 50 and the first planarization layer 30 to affect the overall thickness of the display panel 000, which may be conducive to achieving a thin design.

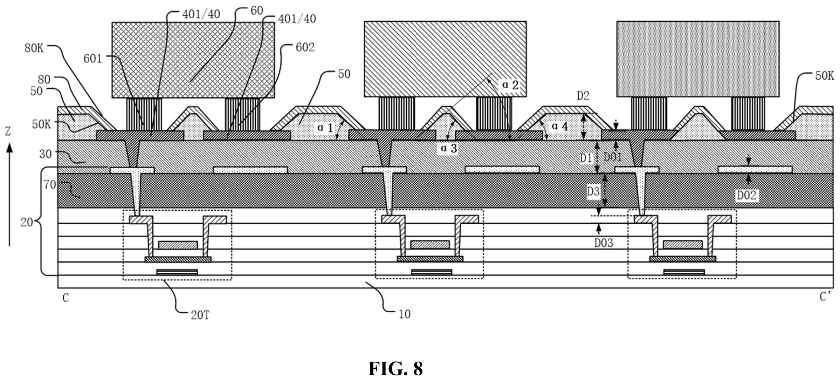

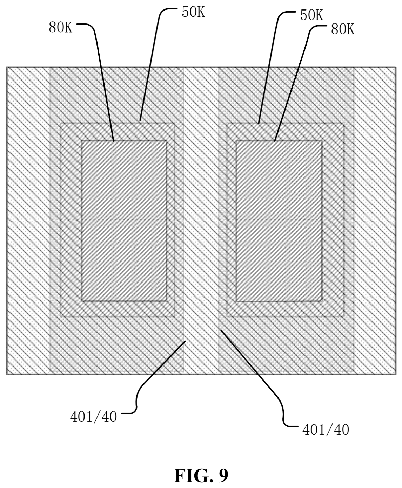

FIG. 8 illustrates a schematic diagram of a C-C'-sectional view in FIG. 1, and FIG. 9 illustrates a schematic diagram of a top view of the first opening, the second opening and the electrode in FIG. 8 (it can be understood that, to clearly illustrate the positional relationship between the first opening and the second opening and the electrode in this embodiment, transparency is filled in FIG. 9). In some embodiments, referring to FIG. 1, FIG. 8 and FIG. 9, in the direction Z perpendicular to the plane in which the substrate 10 is located, one first opening 50K may expose only one electrode 401, and one second opening 80K may expose only one electrode 401.

This embodiment explains that in the film structure of the display panel 000, a second planarization layer 50 may be provided on the patterned first conductive layer 40 to planarize a large number of concave-convex structures formed after patterning first conductive layer 40, and then the second planarization layer 50 may be covered and protected by the first passivation layer 80. Each first opening 50K provided in the second planarization layer 50 and each second opening 80K provided in the first passivation layer 80 may expose only one respective electrode 401. Specifically, in the direction Z perpendicular to the plane in which the substrate 10 is located, one first opening 50K may expose one electrode 401, and one second opening 80K may expose one electrode 401. For an integrated chip of a light-emitting device 60 with a larger size, due to the larger size, the spacing between the anode pin 601 and the cathode pin 602 of the light-emitting device 60 may be larger, so it may be designed in a manner that each bonding point, i.e., each electrode 401, may correspond to a first opening 50K, and each bonding point, i.e., each electrode 401, may correspond to a second opening 80K.

As shown in FIGS. 8-9, a first conductive layer 40 may be fabricated above the driving array layer 20. According to the positions of the anode pin 601 and the cathode pin 602 of the light-emitting device 60 to be bonded subsequently, the first conductive layer 40 may be patterned to form electrodes 401 at corresponding positions. Then, the electrodes 401 may be flattened by the second planarization layer 50. The second planarization layer 50 may be subjected to a hole-opening process to form a first opening 50K at the position of each electrode 401, so that the first opening 50K may expose the middle area of each electrode 401, and the outer edge area of each electrode 401 may be covered and protected by the second planarization layer 50. A first passivation layer 50 may be further provided on the second planarization layer 50. The first passivation layer 80 may cover and protect the second planarization layer 50, and the first passivation layer 80 may be processed to form a second opening 80K at the position of each first opening 50K, so that the first passivation layer 80 may cover the edge of the first opening 50K of the second planarization layer 50 and extend into the first opening 50K to ensure that the surface of the second planarization layer 50 may be completely covered and protected by the first passivation layer 80, and then the corresponding light-emitting device 60 may be transferred and bonded on the electrode 401 to realize the electrical connection between the anode pin 601 of the light-emitting device 60 and the electrode 401, and the electrical connection between the cathode pin 602 of the light-emitting device 60 and the electrode 401.

In one embodiment, a first opening 50K of the second planarization layer 50 may be set to correspond to an electrode 401, so that the area of each first opening 50K for exposing the electrode 401 in the entire second planarization layer 50 may be smaller, and a second opening 80K of the first passivation layer 80 may be set to correspond to an electrode 401, so that the area of each second opening 80K for exposing the electrode 401 in the entire first passivation layer 80 may be smaller. That is, the area of each recessed portion on the upper surface of the substrate may be smaller, which may have little impact on the overall flatness of the substrate surface, and may be conducive to improving the leveling of the ink in the subsequent ink packaging process and ensuring the packaging reliability.

It can be understood that this embodiment is illustrated by taking the packaging form of the light-emitting device 60 as a horizontal light-emitting chip as an example. In a specific implementation, in the direction Z perpendicular to the plane in which the substrate 10 is located, a first opening 50K may correspond to an electrode 401, and a second opening 80K may correspond to an electrode 401. The packaging form of the light-emitting device 60 may also be a vertical light-emitting chip, which will not be described in detail in this embodiment.

In one embodiment, as shown in FIG. 8, the second opening 80K formed in the first passivation layer 80 and the first opening 50K formed in the second planarization layer 50 may have sloped sidewalls, which may be beneficial to improve the leveling performance of the ink and ensure the reliability of the ink encapsulation when the ink is subsequently encapsulated on the side of the first passivation layer 80 away from the substrate 10. In the two electrodes 401 corresponding to the light-emitting device 60, the inclination angle of the sloped sidewall of the first opening 50K along the direction from one electrode 401 to the other electrode 401 may be consistent, the acute angle $\alpha1$, the acute angle $\alpha2$, the acute angle $\alpha3$, and the acute angle $\alpha4$ shown in FIG. 8 may be the same, which may be convenient for simplifying the process and improving the process efficiency. To improve the leveling of the ink encapsulation, the inclination angle of the sloped sidewall of the first opening 50K may be set smaller, that is, the slope at the first opening 50K may be as gentle as possible, which may be beneficial to ensure the leveling of the ink at the first opening 50K during the ink encapsulation and improve the encapsulation reliability.

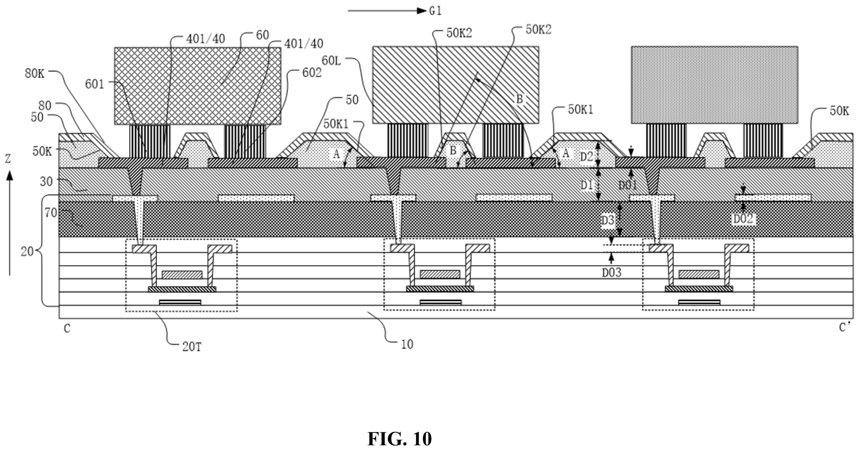

FIG. 10 illustrates another schematic diagram of a C-C'-sectional view in FIG. 1. In some embodiments, referring to FIG. 1 and FIG. 10, the display panel 000 may further include a plurality of light-emitting devices 60. Taking the packaging form of the light-emitting device 60 as a horizontal light-emitting chip as an example, the light-emitting device 60 may be electrically connected to at least two electrodes 401, and the light-emitting device 60 may be electrically connected to the driving array layer 20 through the electrodes 401. In one embodiment, the anode pin 601 of the light-emitting device 60 may be electrically connected to the drain of a thin-film transistor 20T of the driving array layer 20 through an electrode 401, and may provide an anode signal to the anode pin 601 of the light-emitting device 60 through an anode signal power supply line provided by the driving array layer 20. The cathode pin 602 of the light-emitting device 60 may be electrically connected to the cathode signal power supply line of the driving array layer 20 through another electrode 401, and the cathode signal may be provided to the cathode pin 602 of the light-emitting device 60 through the cathode signal power supply line.

An edge of the first opening 50K includes a first slop 50K1 and a second slope 50K2. The first slope is located at a part of the edge away from a center the light-emitting device 60, and the second slope is located at a part of the edge close to the center of the light-emitting device 60. In other words, as shown in FIG. 10, there are the two electrodes 401 of a light-emitting device 60, and along the direction from one electrode 401 to the other electrode 401 (as shown in the direction G1 in FIG. 10), the first opening 50K may have a first slope 50K1 adjacent to the edge 60L of the light-emitting device 60 and a second slope 50K2 away from the edge 60L of the light-emitting device 60.

The angle formed by the first slope 50K1 and the plane in which the substrate 10 is located may be a first acute angle A, and the angle formed by the second slope 50K2 and the plane in which the substrate 10 is located may be a second acute angle B. The acute angle A may be less than the acute angle B.

This embodiment explains that the second opening 80K formed in the first passivation layer 80 and the first opening 50K formed in the second planarization layer 50 may include sloped sidewalls, which may be conducive to improving the leveling performance of the ink and ensuring the reliability of the ink encapsulation when the ink is subsequently encapsulated on the side of the first passivation layer 80 away from the substrate 10. In the two electrodes 401 corresponding to the light-emitting device 60, the inclination angles of the sloped sidewalls of the first opening 50K may be inconsistent along the direction from one electrode 401 to the other electrode 401. For example, in the two electrodes 401 of a light-emitting device 60 shown in FIG. 10, along the direction from one electrode 401 to the other electrode 401 (such as the direction G1 shown in FIG. 10), the first opening 50K may include a first slope 50K1 adjacent to the edge 60L of the light-emitting device 60 and a second slope 50K2 away from the edge 60L of the light-emitting device 60. The acute angle A formed by the first slope 50K1 and the plane in which the substrate 10 is located may be smaller than the acute angle B formed by the second slope 50K2 and the plane in which the substrate 10 is located. That is, in the first opening 50K corresponding to the light-emitting device 60, the first slope S0K1 of the outer first opening 50K may be more gentle, and the second slope 50K2 of the inner first opening 50K may be slightly steeper, thereby ensuring that the ink may have better leveling properties in the peripheral area of the light-emitting device 60 during subsequent ink packaging, thereby improving the packaging effect.

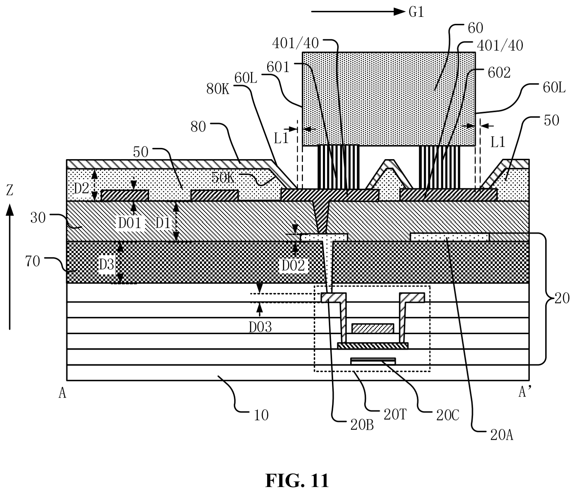

FIG. 11 illustrates another A-A'-sectional view in FIG. 1. In one embodiment, referring to FIG. 1 and FIG. 11, the first conductive layer 40, the second planarization layer 50 and the first passivation layer 80 may be fabricated above the driving array layer 20, and the electrodes 401, the first opening 50K and the second opening 80K may be formed respectively. In the direction from one electrode 401 to another electrode 401 (as shown in the direction G1 in FIG. 11), the minimum distance L1 between the edge 60L of the light-emitting device 60 and the second opening 80K may need to be greater than 3um, that is, the first passivation layer 80 may be used to form the second opening 80K, so that after the first passivation layer 80 covers the second planarization layer 50, according to the size of the light-emitting device 60 to be bonded subsequently, the edge of the first passivation layer 80 at the second opening 80K may need to have a certain distance relative to the edge 60L of the light-emitting device 60, thereby avoiding affecting the subsequent giant transfer and bonding process of the light-emitting device 60, which may be conducive to improving the process yield of giant transfer and bonding process.

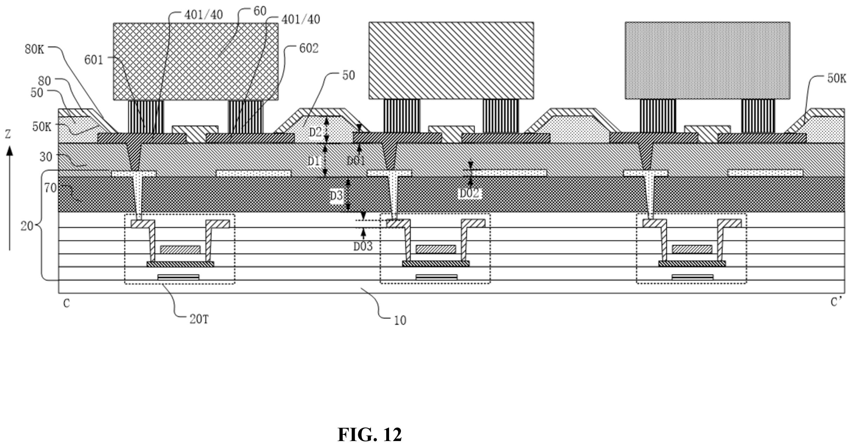

FIG. 12 illustrates another schematic diagram of C-C'-sectional view in FIG. 1 (it can be understood that the positional relationship between the first opening and the second opening and the electrode in FIG. 12 at a top-view angle may be referred to FIG. 7). In some embodiments, referring to FIG. 12 in combination with FIG. 1, the display panel 000 may further include a plurality of light-emitting devices 60. A light-emitting device 60 may be electrically connected to at least two electrodes 401. The light-emitting devices 60 may be electrically connected to the driving array layer 20 through the electrodes 401. In one embodiment, the anode pin 601 of the light-emitting device 60 may be electrically connected to the drain of a thin-film transistor 20T of the driving array layer 20 through one electrode 401 and provide an anode signal to the anode pin 601 of the light-emitting device 60 through the anode signal power supply line set by the driving array layer 20. The cathode pin 602 of the light-emitting device 60 may be electrically connected to the cathode signal power supply line of the drive array layer 20 through another electrode 401, and provide a cathode signal to the cathode pin 602 of the light-emitting device 60 through the cathode signal power supply line.

In the direction Z perpendicular to the plane in which the substrate 10 is located, a first opening 50K may correspond to two electrodes 401 electrically connected to a light-emitting device 60.

In one embodiment, in the direction Z perpendicular to the plane in which the substrate 10 is located, a second opening 80K may expose only one electrode 401. Between two electrodes 401 electrically connected to a light-emitting device 60, the first passivation layer 80 may cover the first planarization layer 30 and a portion of the electrode 401.

This embodiment explains that in the film structure of the display panel 000, a second planarization layer 50 may be provided on the patterned first conductive layer 40 to planarize a large number of concave-convex structures formed after forming the patterned first conductive layer 40, and then the second planarization layer 50 may be covered and protected by the first passivation layer 80. The first opening 50K for exposing the electrode 401 provided in the second planarization layer 50 may correspond to two electrodes 401 electrically connected to one light-emitting device 60, and the second opening 80K for exposing the electrode 401 provided in the first passivation layer 80 may correspond to one electrode 401 one by one. Specifically, in the direction Z perpendicular to the plane in which the substrate 10 is located, one first opening 50K may correspond to two electrodes 401 electrically connected to one light-emitting device 60, and one second opening 80K may correspond to one electrode 401. For an integrated chip of a light-emitting device 60 with a smaller size, due to the smaller size, the spacing between the anode pin 601 and the cathode pin 602 of the light-emitting device 60 may be smaller. Due to the limitation of the process capability, it may be no longer possible to set each electrode 401 in a one-to-one correspondence with the first opening 50K. Therefore, each light-emitting device 60 may include two electrodes 401 electrically connected to each other corresponding to a first opening 50K. For the first passivation layer 80, to fully cover and protect the second planarization layer 50 and the electrode 401, each bonding point, i.e., each electrode 401, may correspond to one second opening 80K.

As shown in FIG. 12 and FIG. 7, a first conductive layer 40 may be fabricated above the driving array layer 20, and the first conductive layer 40 may be patterned according to the positions of the anode pin 601 and the cathode pin 602 of the light-emitting device 60 to be subsequently bonded, and electrodes 401 may be formed at corresponding positions, one light-emitting device 60 may correspond to two electrodes 401. Then, the second planarization layer 50 may be used to cover and flatten the second planarization layer 50, and the second planarization layer 50 may be subjected to a hole-opening process, and the first openings 50K may be formed at the positions of the two electrodes 401 corresponding to each light-emitting device 60, so that the first openings 50K may at least expose portions of the two electrodes 401; and the outer edge areas on both sides of the two electrodes 401 may be covered and protected by the second planarization layer 50. A first passivation layer 80 may be further provided on the second planarization layer 50 to cover and protect the second planarization layer 50, and the first passivation layer 80 may be subjected to a hole-opening treatment, and a second opening 80K may be formed at the position of each electrode 401, so that the first passivation layer 80 may cover the edge of the first opening 50K of the second planarization layer 50, and extend into the first opening 50K, to ensure that the surface of the second planarization layer 50 may be completely covered and protected by the first passivation layer 80, and the two electrodes 401 electrically connected to the same light-emitting device 60 may also be covered by the first passivation layer 80. That is, between the two electrodes 401 electrically connected to a light-emitting device 60, the first passivation layer 80 may cover the first planarization layer 30 and a portion of the electrode 401, and the first passivation layer 80 may play a role in protecting the edge area of the electrode 401, and may also cover and protect the exposed portion of the first planarization layer 30. Then, the corresponding light-emitting device 60 may be transferred and bonded on the electrode 401 to realize the electrical connection between the anode pin 601 of the light-emitting device 60 and the electrode 401, and the electrical connection between the cathode pin 602 of the light-emitting device 60 and the electrode 401. In this embodiment, a first opening 50K of the second planarization layer 50 may be provided corresponding to two electrodes 401 electrically connected to the light-emitting device 60, the second planarization layer 50 may play a flattening role to ensure the leveling of the ink in the subsequent ink packaging process, which may be beneficial to the packaging reliability and may also simplify the process technology, reduce the process difficulty and improve the process efficiency.

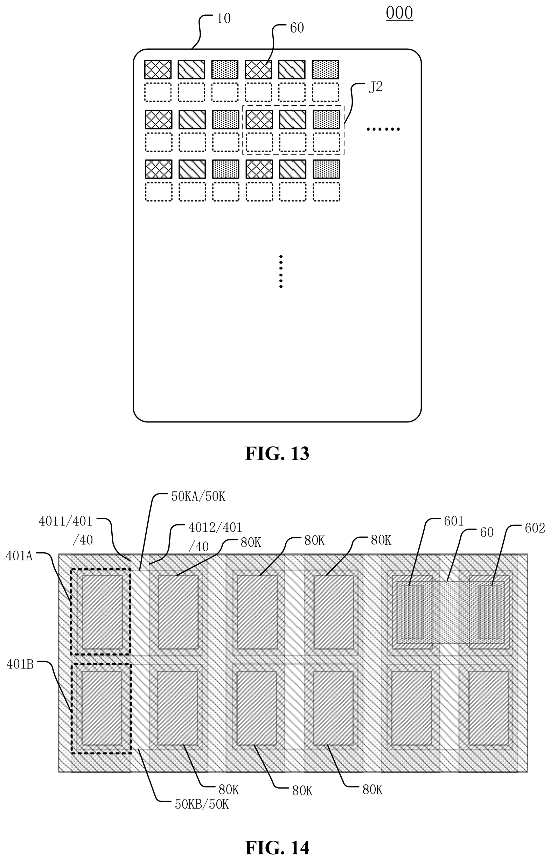

FIG. 13 illustrates a schematic diagram of a top view of an exemplary display panel provided by one embodiment of the present disclosure. FIG. 14 illustrates a schematic diagram of a partially enlarged structure of the J2 area in FIG. 13 (it can be understood that in order to clearly illustrate the structure of this embodiment, FIG. 14 is filled with transparency). As shown in FIGS. 13-14, in some embodiments, the electrode 401 may include a first region 401A and a second region 401B. The two electrodes 401 electrically connected to a light-emitting device 60 may be a first electrode 4011 and a second electrode 4012.

A first opening 50K may include a first sub-opening 50KA and a second sub-opening 50KB. In the direction Z perpendicular to the plane in which the substrate 10 is located, the first sub-opening 50KA may expose the first region 401A of the first electrode 4011 and the first region 401A of the second electrode 4012, and the second sub-opening 50KB may expose the second region 401B of the first electrode 4011 and the second region 401B of the second electrode 4012.

This embodiment explains that in the display panel 000, the electrode 401 used for bonding with the pin of the light-emitting device 60 may include a first region 401A and a second region 401B. The first region 401A of the electrode 401 may be understood as the position where the pin of the light-emitting device 60 is normally bonded to the electrode 401, and the second region 401B may be understood as a preset redundant bonding position. When the display panel is fabricated, the light-emitting device 60, such as micro-LED or mini-LED, may be generally transferred on the motherboard first, and then the motherboard may be cut to form a display panel. After the display panel 000 is cut, a series of process operations may be performed on the display panel 000. During the cutting and fabrication process, the light-emitting device 60 that has been transferred on the display panel 000 may be very easily damaged, which may easily reduce the yield of the display panel. Therefore, in this embodiment, the electrode 401 for bonding with the pin of the light-emitting device 60 may include a first region 401A and a second region 401B. When the light-emitting device 60 is transferred, the normal bonding of the pin of the light-emitting device 60 and the electrode 401 may be first realized in the first region 401A. When it is found during the test that the light-emitting device 60 at a certain position emits abnormal light and cannot emit light normally, the original light-emitting device 60 may be replaced by a repair process, and a new light-emitting device 60 or a repaired light-emitting device 60 may be placed in the second region 401B of the electrode 401 where the light-emitting device 60 has not been placed, thereby ensuring the yield of the product.

In one embodiment, the packaging form of the light-emitting device 60 may be a horizontal light-emitting chip, and the two electrodes 401 electrically connected to a light-emitting device 60 may be defined as the first electrode 4011 and the second electrode 4012. Then, the first opening 50K formed in the second planarization layer 50 may include a first sub-opening 50KA and a second sub-opening 50KB. In the direction Z perpendicular to the plane in which the substrate 10 is located, the first sub-opening 50KA may expose the first region 401A of the first electrode 4011 and the first region 401A of the second electrode 4012. That is, the first sub-opening 50KA of the first opening 50K may expose the normal bonding area of the two electrodes 401 electrically connected to a light-emitting device 60 and the second sub-opening 50KB may expose the second region 401B of the first electrode 4011 and the second region 401B of the second electrode 4012, that is, the second sub-opening 50KB of the first opening 50K may expose the redundant bonding area of the two electrodes 401 electrically connected to a light-emitting device 60, so that the first opening 50K may correspond to a light-emitting device 60, and the first opening 50K may expose both the normal bonding positions of the two electrodes 401 electrically connected to a light-emitting device 60 and the redundant bonding position of the two electrodes 401 electrically connected to a light-emitting device 60, which may be convenient for the subsequent normal transfer and repair of the light-emitting device 60. It can be understood that to clarify the structure in schematic diagram in FIG. 14, FIG. 14 only draws one light-emitting device 60.

In one embodiment, as shown in FIG. 14, a first opening 50K may include a first sub-opening 50KA and a second sub-opening 50KB. The first sub-opening 50KA and the second sub-opening 50KB may be two independent sub-openings, that is, the opening of the second planarization layer 50 corresponding to the redundant bonding position of the two electrodes 401 electrically connected to a light-emitting device 60 and the opening of the second planarization layer 50 corresponding to the normal bonding position of the two electrodes 401 electrically connected to a light-emitting device 60 may be independent of each other.

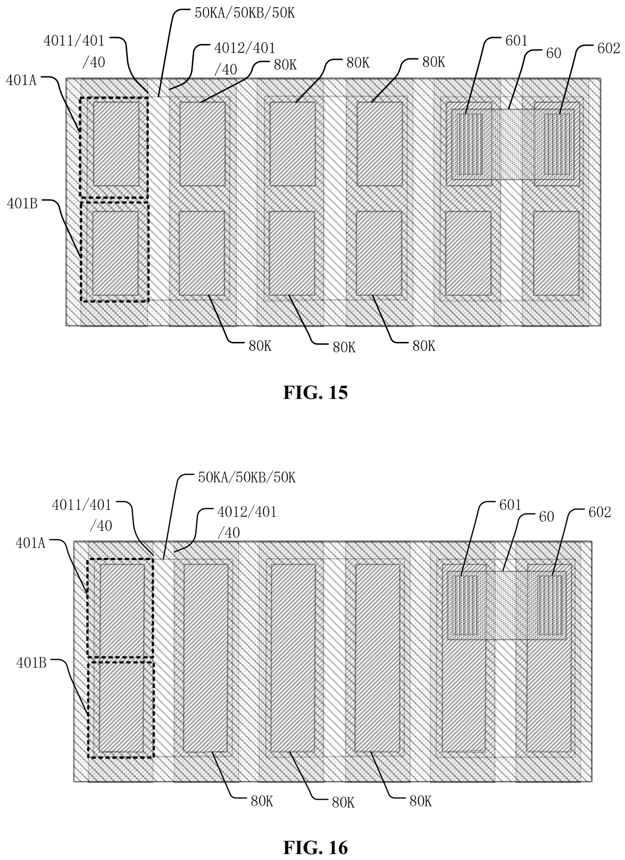

FIG. 15 is another partially enlarged structural schematic diagram of the J2 area in FIG. 13 (it can be understood that in order to clearly illustrate the structure of this embodiment, FIG. 15 is filled with transparency). As shown in FIG. 15, in some embodiments, a first opening 50K may include a first sub-opening 50KA and a second sub-opening 50KB. The first sub-opening 50KA and the second sub-opening 50KB may be interconnected, that is, the opening of the second planarization layer 50 corresponding to the redundant bonding positions of the two electrodes 401 electrically connected to a light-emitting device 60 and the opening of the second planarization layer 50 corresponding to the normal bonding positions of the two electrodes 401 electrically connected to a light-emitting device 60 may be an integral first opening 50K, which may be used to meet the requirement of exposing the two electrodes 401 corresponding to the light-emitting device 60. In specific implementations, sub-openings may be selected and set according to actual needs.

In another embodiment, as shown in FIG. 14 and FIG. 15, one electrode 401 may correspond to two second openings 80K formed in the first passivation layer 80. Specifically, the first region 401A of the first electrode 4011 may correspond to one second opening 80K, the second region 401B of the first electrode 4011 may correspond to one second opening 80K, the first region 401A of the second electrode 4012 may correspond to one second opening 80K, and the second region 401B of the second electrode 4012 may correspond to one second opening 80K, thereby ensuring the covering and protecting effect of the first passivation layer 80 on the second planarization layer 50, the electrode 401 and the first planarization layer 30.

FIG. 16 illustrates another partially enlarged structural schematic diagram of the J2 region in FIG. 13 (it can be understood that, in order to clearly illustrate the structure of this embodiment, FIG. 16 is filled with transparency). As shown in FIG. 16, in one embodiment, the second opening 80K formed in the first passivation layer 80 may still be a relationship in which one second opening 80K may correspond to one electrode 401, that is, the first region 401A and the second region 401B of the electrode 401 may together correspond to one second opening 80K, thereby ensuring the first passivation layer 80 to cover and protect the second planarization layer 50, the electrode 401 and the first planarization layer 30.

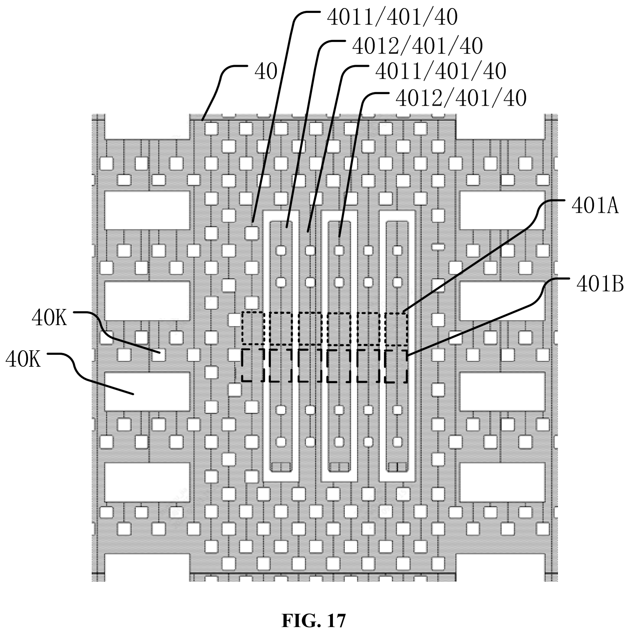

FIG. 17 illustrates a partial structural schematic diagram of the first conductive layer in FIG. 1 and FIG. 13. Referring to FIG. 1-FIG. 2, FIG. 13 and FIG. 17, in some embodiments, the first conductive layer 40 may include a plurality of through holes 40K, and the orthographic projection of the through holes 40K on the substrate 10 may not overlap with the orthographic projection of the first region 401A of the electrode 401 and the second region 401B of the electrode 401 on the substrate 10.

This embodiment explains that the first conductive layer 40 may include other patterned conductive structures in addition to the plurality of electrodes 401. The electrode structure of the first conductive layer 40 may be mainly used to power the cathode pin of the corresponding light-emitting device through the electrode 401 and to power the anode pin of the corresponding light-emitting device through the electrode 401. The electrodes 401 (i.e., cathode bonding electrodes) electrically connected to the cathode pins of different light-emitting devices 60 may be connected into a whole surface structure (as shown in FIG. 17). The first conductive layer 40 may include a large number of through holes 40K. The sizes and shapes of different through holes 40K may be different. The opening of the through holes 40K may prevent the peeling of the surface film layer in the process of the first conductive layer 40. In one embodiment, the orthographic projection of the through hole 40K on the substrate 10 may not overlap with the orthographic projection of the first region 401A of the electrode 401 and the second region 401B of the electrode 401 on the substrate 10, which may avoid the unstable bonding caused by the existence of the through hole 40K when the light-emitting device 60 is bonded, thereby facilitating the product yield.

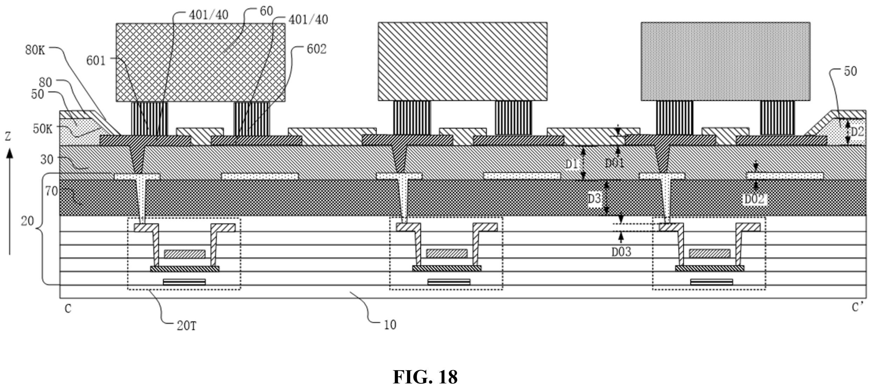

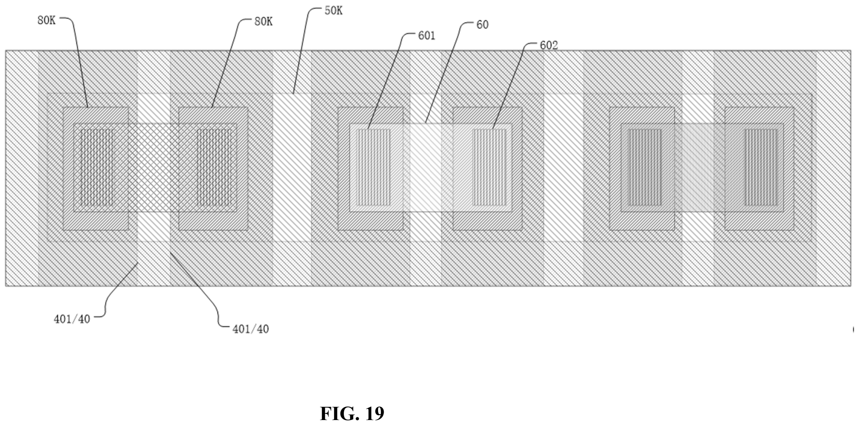

FIG. 18 illustrates another C-C'-sectional view in FIG. 1, and FIG. 19 illustrates a top view of the first opening, the second opening, and the electrode in FIG. 18 (it can be understood that in order to clearly illustrate the positional relationship between the first opening and the second opening and the electrode in this embodiment, transparency is filled in FIG. 19). Referring to FIG. 1 and FIG. 18 and FIG. 19, in some embodiments, the display panel 000 may further include a plurality of light-emitting devices 60. The light-emitting devices 60 may be electrically connected to at least two electrodes 401. The light-emitting devices 60 may be electrically connected to the driving array layer 20 through the electrodes 401.

In one embodiment, the anode pin 601 of the light-emitting device 60 may be electrically connected to the drain of a thin-film transistor 20T of the driving array layer 20 through an electrode 401 and may provide the anode pin 601 of the light-emitting device 60 through the anode signal power supply line set by the driving array layer 20. The cathode pin 602 of the light-emitting device 60 may be electrically connected to the cathode signal power supply line of the driving array layer 20 through another electrode 401, and provide a cathode signal to the cathode pin 602 of the light-emitting device 60 through the cathode signal power supply line.

In the direction Z perpendicular to the plane where substrate 10 is located, a first opening 50K may correspond to three adjacent light-emitting devices 60 of different colors.

In one embodiment, in the direction Z perpendicular to the plane in which the substrate 10 is located, a second opening 80K may correspond to an electrode 401. Between two electrodes 401 electrically connected to a light-emitting device 60, and between two adjacent light-emitting devices 60, the first passivation layer 80 may cover the first planarization layer 30 and a portion of the electrode 401.

This embodiment explains that in the film structure of the display panel 000, a second planarization layer 50 may be provided above the patterned first conductive layer 40 to planarize a large number of concave-convex structures formed after patterning first conductive layer 40, and then the second planarization layer 50 may be covered and protected by the first passivation layer 80. The first opening 50K formed in the second planarization layer 50 for exposing the electrode 401 may correspond to six electrodes 401 electrically connected to three adjacent light-emitting devices 60 of different colors, that is, the first opening 50K may correspond to three light-emitting devices 60 of different colors included in a pixel unit. The second opening 80K formed in the first passivation layer 80 for exposing the electrode 401 may correspond to one-to-one with the electrode 401. Specifically, in the direction Z perpendicular to the plane in which the substrate 10 is located, one first opening 50K may correspond to six electrodes 401 electrically connected to three adjacent light-emitting devices 60 of different colors, and one second opening 80K may correspond to one electrode 401. For a display panel with a high pixel density, smaller light-emitting devices may be required, and the interval between adjacent light-emitting devices may need to be minimized. Therefore, for an integrated chip with smaller light-emitting devices 60, due to the smaller size, the spacing between the anode pin 601 and the cathode pin 602 of the light-emitting device 60 may need to be smaller, and the spacing between adjacent light-emitting devices may also need to be smaller. Due to the limitation of process capabilities, it may be no longer possible to set each electrode 401 in a one-to-one correspondence with the first opening 50K. Therefore, the six electrodes 401 electrically connected to the three light-emitting devices 60 of different colors in a pixel unit may correspond to one first opening 50K. To allow the first passivation layer 80 to play a role in completely covering and protecting the second planarization layer 50 and the electrode 401, each bonding point, i.e., each electrode 401, may individually correspond to one a second opening 80K.

As shown in FIGS. 18-19, a first conductive layer 40 may be fabricated above the driving array layer 20, and the first conductive layer 40 may be patterned according to the positions of the anode pin 601 and the cathode pin 602 of the light-emitting device 60 to be subsequently bonded to form electrodes 401 at the corresponding positions, and one light-emitting device 60 may correspond to two electrodes 401. Then, the second planarization layer 50 may be used to cover and flatten the structure, and the second planarization player 50 may be subject to the hole-opening process to form a relatively large first opening 50 in the area of the six electrodes 401 electrically connected to light-emitting devices 60 of three different colors in a pixel unit, so that the first opening 50K may at least expose a portion of the six electrodes 401, and the outer edge regions on both sides of the two outermost electrodes 401 of the six electrodes 401 may be covered and protected by the second planarization layer 50. A first passivation layer 80 may be further disposed on the second planarization layer 50 to cover and protect the second planarization layer 50, and the first passivation layer 80 may be subject to a hole-opening process to form a second opening 80K at the position of each electrode 401, so that the first passivation layer 80 may cover the edge of the first opening 50K of the second planarization layer 50, and extend into the first opening 50K, ensuring that the surface of the second planarization layer 50 may be completely covered and protected by the first passivation layer 80, and the two electrodes 401 electrically connected to the same light-emitting device 60 may also be covered by the first passivation layer 80. That is, between the two electrodes 401 electrically connected to a light-emitting device 60, the first passivation layer 80 may cover the first planarization layer 30 and a portion of the electrode 401, and between two adjacent light-emitting devices 60, the first passivation layer 80 may also cover the first planarization layer 30 and a portion of the electrode 401. Through the protection role of the first passivation layer 80 to the edge area of the electrode 401, the exposed portion of the first planarization layer 30 may also be covered and protected. Then, the transfer pressing and bonding process may be performed to the corresponding light-emitting device 60 on the electrode 401 to realize the electrical connection between the anode pin 601 of the light-emitting device 60 and the electrode 401, and the electrical connection between the cathode pin 602 of the light-emitting device 60 and the electrode 401. In one embodiment, a first opening 50K of the second planarization layer 50 may be arranged to correspond to three light-emitting devices 60 of different colors in a pixel unit, the second planarization layer 50 may play a leveling role to ensure the leveling of the ink during the subsequent ink packaging process, which may be beneficial to the packaging reliability and may also simplify the process technology, reduce the process difficulty and improve the process efficiency.

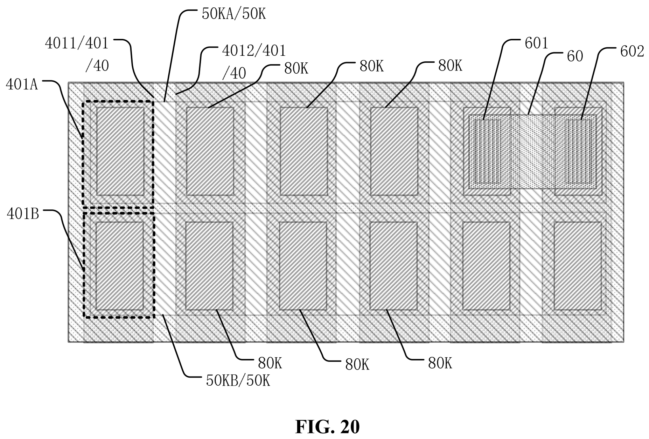

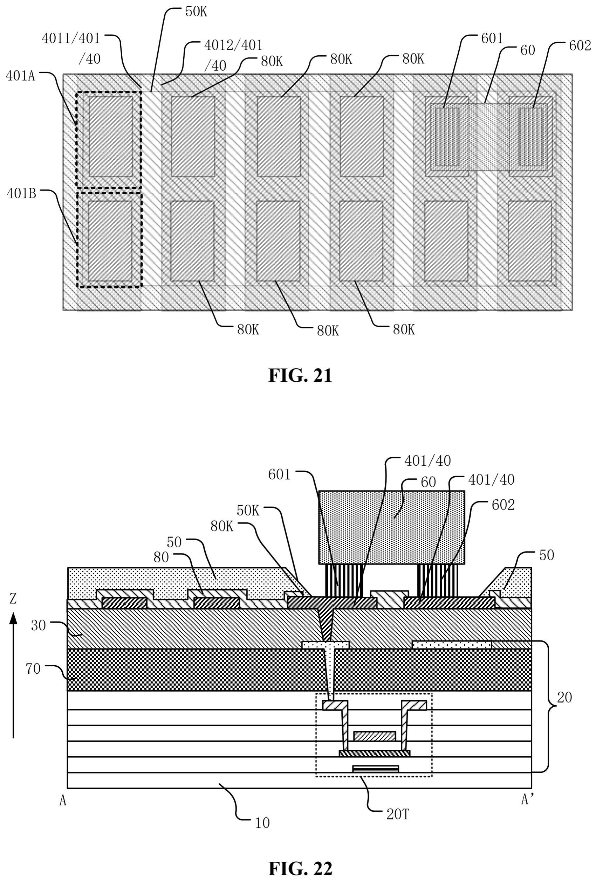

FIG. 20 illustrates another partially enlarged structural schematic diagram of the J2 area in FIG. 13, and FIG. 21 illustrates another partially enlarged structural schematic diagram of the J2 area in FIG. 13 (it can be understood that in order to clearly illustrate the structures, FIG. 20 and FIG. 21 are filled with transparency). In one embodiment, as shown in FIG. 13, FIG. 20 and FIG. 21, in the display panel 000, when the electrode 401 for bonding with the pin of the light-emitting device 60 includes a first region 401A and a second region 401B, the first region 401A of the electrode 401 may be understood as the normal bonding position of the pin of the light-emitting device 60 and the electrode 401, the second region 401B may be understood as a preset redundant bonding position, the first sub-opening 50KA of a first opening 50K of the second planarization layer 50 may be set to correspond to the first region 401A of the six electrodes 401, and the second sub-opening 50KB of the first opening 50K may be set to correspond to the second region 401B of the six electrodes 401 (as shown in FIG. 20). In another embodiment, the first opening 50K of the second planarization layer 50 may be set to correspond to the first region 401A and the second region 401B of the six electrodes 401 (as shown in FIG. 21) to improve the process efficiency and reduce the process difficulty.

FIG. 22 illustrates another A-A'-sectional view in FIG. 1. In some embodiments, as shown in FIG. 1 and FIG. 22, the display panel may further include a first passivation layer 80. The first passivation layer 80 may be located between the second planarization layer 50 and the first conductive layer 40.

The first passivation layer 80 may include a plurality of second openings 80K. The orthographic projection of the second opening 80K on the substrate 10 may partially overlap with the orthographic projection of the electrode 401 on the substrate 10. At a periphery of the second opening 80K, the first passivation layer 80 may at least cover a portion of the electrode 401 in the direction Z perpendicular to the plane in which the substrate 10 is located.

This embodiment explains that the film layer structure of the display panel 000 may also include a first passivation layer 80. The first passivation layer 80 may be arranged on the side of the second planarization layer 50 facing the substrate 10, and the first passivation layer 80 may be located between the second planarization layer 50 and the first conductive layer 40. The first passivation layer 80 may be an inorganic film layer. The first passivation layer 80 may be used to protect the film layer of the display panel 000, especially to protect the first planarization layer 30 of the organic material, and to play a protective effect of isolating water and oxygen corrosion.

The first passivation layer 80 may include a plurality of second openings 80K. The orthographic projection of the second opening 80K on the substrate 10 may partially overlap with the orthographic projection of the electrode 401 on the substrate 10. At a periphery of the second openings 80K (if the second openings 80K are square, this direction refers to surrounding the edges of the square; if the second openings 80K are circular, this direction refers to surrounding the edges of the circular), the first passivation layer 80 may cover at least a portion of the electrode 401 in a direction perpendicular to the plane in which the substrate 10 is located. The second openings 80K may be used to expose at least a portion of the electrode 401, so as to facilitate the subsequent bonding of the light-emitting device 60 to the electrode 401 in the overlapping second openings 80K. The first passivation layer 80 of this embodiment may be formed after the first conductive layer 40 and before the second planarization layer 50. After the first conductive layer 40 is patterned, the first passivation layer 80 may cover and protect the edge of the electrode 401 and the surface of the first planarization layer 30 exposed by the electrode 401, thereby improving the effect of isolating the substrate from water and oxygen erosion. Then, the second planarization layer 50 may be formed, and a plurality of first openings 50K may be formed. At this time, the orthographic projection of the first opening 50K on the substrate 10 may overlap with the orthographic projection of the electrode 401 on the substrate 10 at least partially, so that the first opening 50K may also expose a portion of the electrode 401. The second planarization layer 50 of this embodiment may cover the edge of the first passivation layer 80, or may not cover the edge of the first passivation layer 80. At this time, the edges of the first planarization layer 30 and the electrode 401 may be covered and protected by the first passivation layer 80, and the second planarization layer 50 may only need to play the role of flattening the concave-convex structures on the surface of the substrate.

It is understandable that in this embodiment, other inorganic layers may be provided on the side of the second planarization layer 50 away from the substrate 10 to protect the second planarization layer 50 from water and oxygen corrosion.

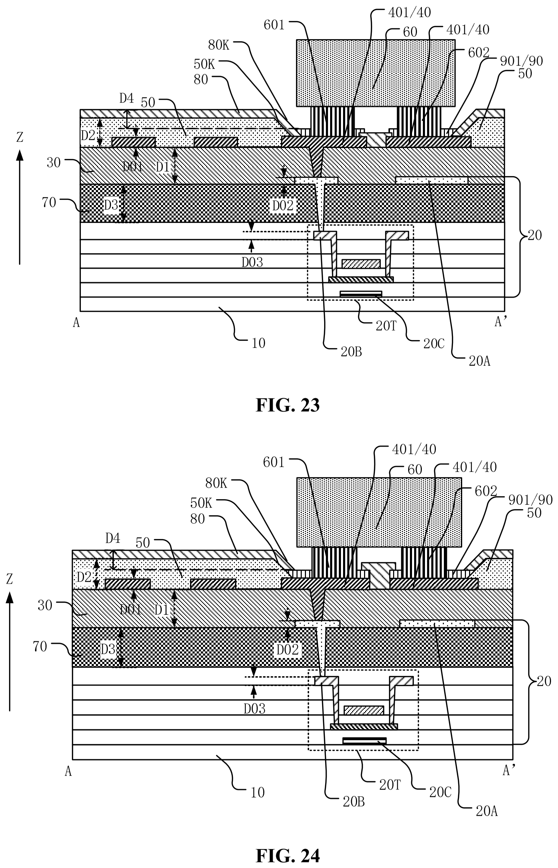

FIG. 23 illustrates another A-A'-sectional view in FIG. 1. As shown in FIG. 1 and FIG. 23, in some embodiments, the display panel 000 may further include a third conductive layer 90. The third conductive layer 90 may include a plurality of gap fills 901.

The gap fill 901 may be in direct contact with the electrode 401. The orthographic projection of the gap fill 901 on the substrate 10 may at least partially overlap with the orthographic projection of the electrode 401 on the substrate 10.

The display panel 000 may further include a plurality of light-emitting devices 60. The light-emitting devices 60 may be electrically connected to the driving array layer 20 through the electrode 401 and the gap fill 901. In one embodiment, the anode pin 601 of the light-emitting device 60 may be electrically connected to the drain of a thin-film transistor 20T of the driving array layer 20 through an electrode 401 and a gap fill 901 directly in contact with the electrode 401, and provide anode signal to the anode pin 601 of the light emitting device 60 through an anode signal power supply line provided by the driving array layer 20. The cathode pin 602 of the light emitting device 60 may be electrically connected to the cathode signal power supply line of the driving array layer 20 through another electrode 401 and a gap fill 901 directly in contact with the electrode 401, and provide a cathode signal to the cathode pin 602 of the light-emitting device 60 through the cathode signal power supply line.

This embodiment explains that the second planarization layer 50 may be provided on a side of the patterned first conductive layer 40 away from the substrate 10 to flatten the surface of the first conductive layer 40 away from the substrate 10, so that the surface of the patterned first conductive layer 40 may be covered by the second planarization layer 50 of organic material, and a large number of concave-convex structures presented by the patterned first conductive layer 40 may be flattened by the second planarization layer 50 to improve the flatness problem of the substrate and improve the effect of subsequent ink encapsulation. A third conductive layer 90 may also be included in the film structure of the display panel 000. The third conductive layer 90 may be graphically designed to form a plurality of gap fills 901. The gap fills 901 may correspond one to one with the electrodes 401. In the direction Z perpendicular to the plane in which the substrate 10 is located, the gap fills 901 may be in direct contact with the electrodes 401, and the orthographic projection of the gap fills 901 on the substrate 10 may at least partially overlap with the orthographic projection of the electrodes 401 on the substrate 10. Because the first opening 50K formed in the second planarization layer 50 may expose at least a portion of the electrode 401 for subsequent giant transfer and bonding of the light-emitting device 60, the second planarization layer 50 may need to have a certain thickness in order to flatly cover the large number of concave and convex structures presented by the patterned first conductive layer 40. Therefore, after the second planarization layer 50 is set, the step difference between the upper surface of the electrode 401 and the upper surface of the second planarization layer 50 may increase, which may affect the macro rotation process of the light-emitting device 60. In one embodiment, a gap fill 901 may be superimposed on the electrode 401. By superimposing the thickness of the gap fill 901 on the electrode 401, the problem of the step difference around the light-emitting device 60 caused by the setting of the second planarization layer 50 may be reduced, which may be beneficial to the subsequent giant process of the light-emitting device 60.

It can be understood that this embodiment does not limit the material of the third conductive layer 90. The third conductive layer 90 may be the same as the material of the first conductive layer 40 or different. The material of the third conductive layer 90 may be a metal material or a transparent conductive material. This embodiment does not limit this.

In one embodiment, as shown in FIG. 23, along the direction Z perpendicular to the plane in which the substrate 10 is located, the gap fill 901 may include a first surface 901A on the side away from the electrode 401, and the second planarization layer 50 may include a second surface 50A on the side away from the substrate 10. If the second planarization layer 50 may also include a first passivation layer 80 on the side away from the substrate 10, the second surface 50A may be understood as the surface of the first passivation layer 80 on the side away from the substrate 10. The distance D4 between the first surface 901A and the second surface 50A may range from 0.1 um to 2 um, which may avoid the gap fill 901 provided by the third conductive layer 90 from being too thick and affecting the thin design after the display panel is packaged. It may also avoid the gap fill 901 provided by the third conductive layer 90 from being too thin, which will still have a large step difference after being superimposed on the electrode 401, which is not conducive to the subsequent giant rotation process of the light-emitting device 60.

In one embodiment, the plurality of light-emitting devices 60 may include light-emitting devices of different colors. Due to different processes, the thickness of the different light-emitting devices 60 may be different, that is, the thickness in the direction Z perpendicular to the plane in which the substrate 10 is located may be different. To ensure the flatness of the display panel after the overall packaging, it may be set in the direction Z perpendicular to the plane in which the substrate 10 is located. The thickness of the gap fill 901 corresponding to the light-emitting device 60 with a larger thickness may be relatively small, and the thickness of the gap fill 901 corresponding to the light-emitting device 60 with a smaller thickness may be relatively thick, thereby balancing the height difference of different light-emitting devices 60 on the substrate 10 after the giant transfer and bonding, and finally making the distance from the surface of the light-emitting device 60 with a larger thickness away from the substrate 10 to the substrate 10 to be same as the distance from the surface of the light-emitting device 60 with a thinner thickness away from the substrate 10 to the substrate 10 as much as possible, which may be beneficial to improving the flatness of the subsequent packaging of the panel and reducing the packaging difficulty.

In one embodiment, as shown in FIG. 1 and FIG. 23, the third conductive layer 90 may be located on the side of the first passivation layer 80 away from the substrate 10. In another embodiment, as shown in FIG1 and FIG. 24 that is another A-A'-sectional view in FIG1, the third conductive layer 90 may be located between the first passivation layer 80 and the second planarization layer 50. The orthographic projection of the gap fill 901 on the substrate 10 may be located within the orthographic projection range of the electrode 401 on the substrate 10.

This embodiment explains that the third conductive layer 90 used to raise the thickness of the electrode 401 to reduce the step difference may be set on the side of the first passivation layer 80 away from the substrate 10, that is, it may be set in the second opening 80K of the first passivation layer 80 after the first passivation layer 80 is formed. Alternatively, the third conductive layer 90 used to raise the thickness of the electrode 401 to reduce the step difference may be set between the first passivation layer 80 and the second planarization layer 50, that is, after the second planarization layer 50 is formed, a plurality of first openings 50K may be formed to expose a portion of the electrode 401, and then the third conductive layer 90 may be set in the first opening 50K, and a plurality of gap fills 901 may be formed. The gap fills 901 may be directly in contact with the electrode 401, and then the first passivation layer 80 may be set, and the patterned first passivation layer 80 may cover the second planarization layer 50 and the edge area of the gap fill 90, and the first passivation layer 80 of inorganic material may perform a water-oxygen isolation effect to improve the reliability of the substrate.

In one embodiment, the third conductive layer 90 may be made of a metal material, and the orthographic projection of the gap fill 901 on the substrate 10 may be located within the orthographic projection range of the electrode 401 on the substrate 10, which may prevent the electrode 401 from being over-etched and affecting the conductive performance of the electrode 401. It is understandable that in this embodiment, the shapes of the gap fill 901 and the electrode 401 may be the same, for example, the shapes of the orthographic projection on the substrate 10 may both be long strips, so that the gap fill 901 and the electrode 401 may be stacked one by one. The size relationship between the gap fill 901 and the electrode 401 may be that, in the two electrodes 401 electrically connected to the light-emitting device 60, along the direction from one electrode 401 to the other electrode 401, the width of the gap fill 901 may be less than or equal to the width of the electrode 401, so as to form an effect that the orthographic projection of the gap fill 901 on the substrate 10 may be located within the orthographic projection range of the electrode 401 on the substrate 10.

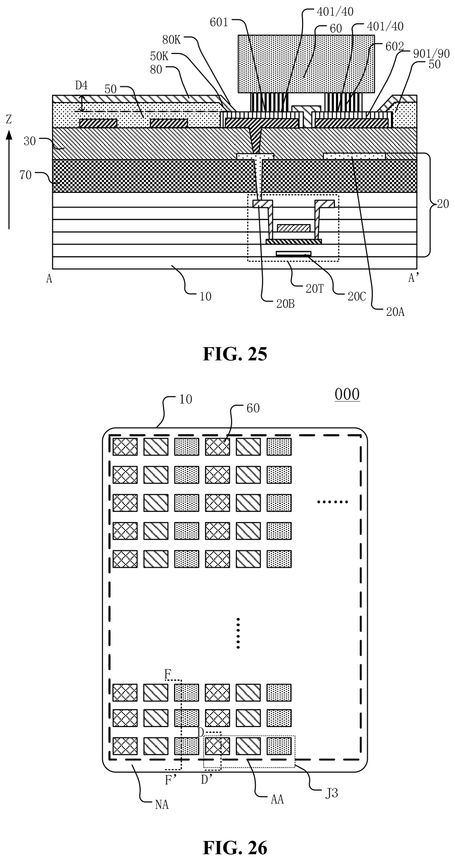

FIG. 25 illustrates another A-A'-sectional view FIG. 1. As shown in FIG. 1 and FIG. 25, in one embodiment, the third conductive layer 90 may be located between the first conductive layer 40 and the second planarization layer 50. The orthographic projection of the gap fill 901 on the substrate 10 may cover the orthographic projection of the electrode 401 on the substrate 10.

This embodiment explains that the third conductive layer 90 used to raise the thickness of the electrode 401 to reduce the step difference may be arranged between the first conductive layer 40 and the second planarization layer 50, that is, after the plurality electrodes 401 of the first conductive layer 40 are formed, the third conductive layer 90 may be formed and then patterned to form the plurality of gap fills 901 directly in contact with the electrode 401, and then the second planarization layer 50 and other structures may be formed. In one embodiment, the third conductive layer 90 may be made of a metal material, and the orthographic projection of the gap fill 901 on the substrate 10 may cover the orthographic projection of the electrode 401 on the substrate 10. In the two electrodes 401 electrically connected to the light-emitting device 60, the width of the gap fill 901 may be greater than the width of the electrode 401 in the direction from one electrode 401 to the other electrode 401, so as to form an effect that the orthographic projection of the gap fill 901 on the substrate 10 may cover the orthographic projection of the electrode 401 on the substrate 10. By directly contacting and covering the electrode 401 with the gap fill 901, the electrode 401 may be prevented from being over-etched when the first opening 50K of the second planarization layer 50 is subsequently formed, which may be conducive to ensuring the conductive performance of the electrode 401.

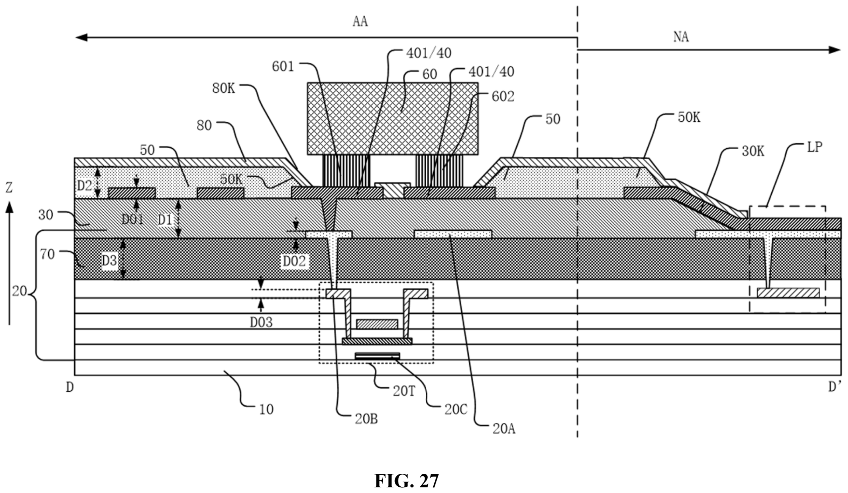

FIG. 26 illustrates another schematic diagram of the planar structure of the display panel provided by one embodiment of the present disclosure, and FIG. 27 illustrates a schematic diagram of a D-D'-sectional view in FIG. 26. As shown in FIGS. 26-27, in some embodiments, the first planarization layer 30 may include a plurality of third openings 30K, and in the direction Z perpendicular to the plane in which the substrate 10 is located, the third openings 30K may at least partially overlap with the first openings 50K. That is, an orthographic projection of the third opening 30K on the substrate overlap with the orthographic projection of the first opening 50K on the substrate. In one embodiment, the display panel 000 may include a frame area NA and a non-frame area AA, and the frame area NA may be at least partially arranged around the non-frame area AA. The frame area NA may be understood as the edge area of the display panel 000, and the non-frame area AA may be understood as the area at least partially surrounded by the frame area NA, and may also be understood as the light-emitting or display area of the display panel 000.

In one embodiment, the plurality of first openings 50K of the second planarization layer 50 may pass through the thickness of the second planarization layer 50. Among the plurality of first openings 50K, a portion of the first openings 50K may be located in the frame area of the display panel 000. The first planarization layer 30 on the side of the first conductive layer 40 facing the substrate 10 may also include a plurality of third openings 30K. In the direction Z perpendicular to the plane in which the substrate 10 is located, the third openings 30K may pass through the thickness of the first planarization layer 30, and the third openings 30K may at least partially overlap with the first openings 50K. That is, in the frame area of the display panel 000, both the first planarization layer 30 and the second planarization layer 50 may include openings, and the third openings 30K may at least partially overlap with the first openings 50K, so that the conductive layer of the frame area NA of the display panel 000 may be exposed, and may be used as a bonding pad LP of the peripheral signal wiring and other structures for transmitting the driving signal.

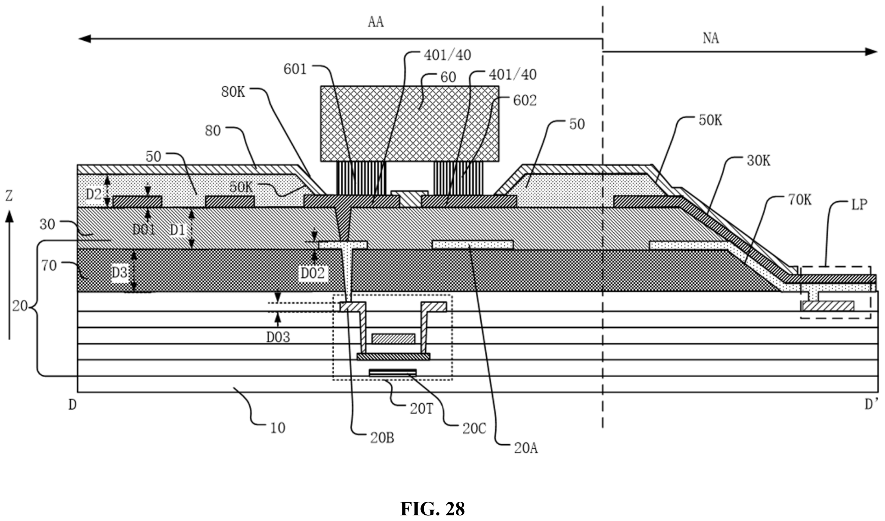

FIG. 28 illustrates another D-D'-sectional view in FIG. 26. In one embodiment, as shown in FIG. 26 and FIG. 28, when the film layer structure of the display panel 000 also includes a third planarization layer 70 located on the side of the first planarization layer 30 adjacent to the substrate 10, the third planarization layer 70 may also include a plurality of fourth openings 70K. In the direction Z perpendicular to the plane in which the substrate 10 is located, the fourth openings 70K may pass through the thickness of the third planarization layer 70, and the fourth openings 70K, the third openings 30K and the first openings 50K may at least partially overlap.

Further, in one embodiment, as shown in FIG. 26 and FIG. 28, in the frame area NA, the first opening 50K may expose the third opening 30K, and the third opening 30K may expose the fourth opening 70K. That is, in the direction from the frame area NA to the non-frame area AA, the opening width of the first opening 50K may be greater than the opening width of the third opening 30K, and the opening width of the third opening 30K may be greater than the opening width of the fourth opening 70K. In the frame area NA, the third opening 30K of the first planarization layer 30 may be inwardly contracted compared to the fourth opening 70K of the third planarization layer 70, and the first opening 50K of the second planarization layer 50 may be inwardly contracted compared to the third opening 30K of the first planarization layer 30, that is, along the direction away from the substrate 10, the openings of different planarization layers in the frame area NA may gradually contract toward the non-frame area AA, which may avoid the peeling problem of the metal conductive layer set at the steps of each opening in the frame area NA, and may also avoid the peeling problem caused by the mutual adhesion between the planarization layers.

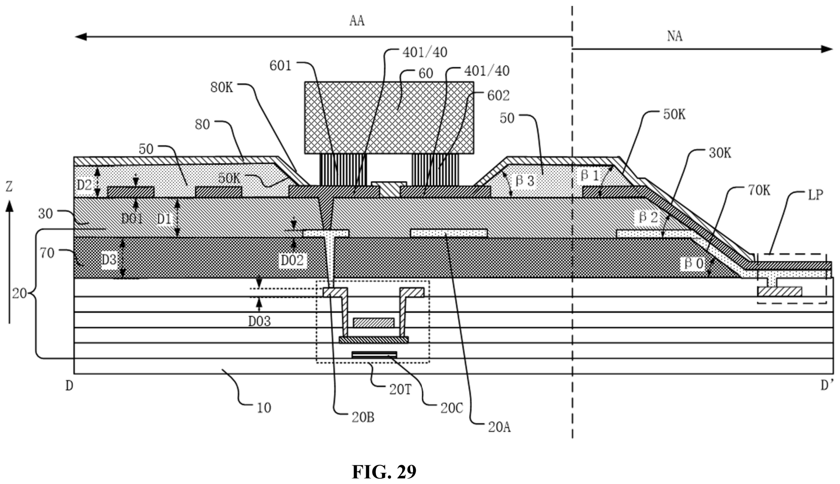

FIG. 29 illustrates another D-D'-sectional view in FIG. 26. As shown in FIG. 26 and FIG. 29, in some embodiments, in the frame area NA, the first opening 50K may include a first inclined surface 50K0, and the third opening 30K may include a second inclined surface 30K0. The first inclined surface 50K0 may form a first acute angle β1 with the plane in which the substrate 10 is located, and the second inclined surface 30K0 may form a second acute angle β2 with the plane in which the substrate 10 is located. The first acute angle β1 may be greater than the second acute angle β2.

This embodiment explains that the slopes of the first opening 50K of the second planarization layer 50 and the third opening 30K of the first planarization layer 30 in the frame area NA may be different, and the first inclined surface 50K0 of the first opening 50K may form a first acute angle β1 with the plane in which the substrate 10 is located, which may be greater than the second acute angle β2 formed by the second inclined surface 30K0 of the third opening 30K with the plane in which the substrate 10 is located. That is, in the frame area NA, the inclined surface of the third opening 30K of the first planarization layer 30 may be a gentle slope compared with the inclined surface of the first opening 50K of the second planarization layer 50, while the inclined surface of the first opening 50K may be a steep slope. The first acute angle β1 formed between the first inclined surface 50K0 of the first opening 50K and the plane in which the substrate 10 is located may be set to be larger, which may improve the ink packaging fluidity at the discontinuity of the second planarization layer 50 in the frame area NA during the ink packaging, and there is no other metal conductive layer on the surface of the second planarization layer 50 away from the substrate 10, so there may be no need to worry about the problem of metal residual short circuit at the first inclined surface 50K0 of the first opening 50K. The first acute angle β1 formed between the first inclined surface 50K0 of the first opening 50K and the plane in which the substrate 10 is located may be set to be larger, which may also make the overall coverage area of the second planarization layer 50 in the frame area NA larger and thicker, and may effectively cover the structure of the first conductive layer 40 in the frame area NA. In this embodiment, the second acute angle β2 formed between the second inclined surface 30K0 of the third opening 30K and the plane in which the substrate 10 is located is set to be smaller, that is, the inclined surface of the third opening 30K may be a gentle slope, which may reduce the probability of the metal layer (such as the first conductive layer 40) on the surface of the first planarization layer 30 remaining at the third opening 30K, which may be conducive to improving the process yield and display quality.

In one embodiment, as shown in FIG. 29, the slope angle of the fourth opening 70K of the third planarization layer 70 in the frame area NA may be the same as the slope angle of the third opening 30K, that is, the slope of the fourth opening 70K in the frame area NA may form an acute angle β0 with the plane in which the substrate 10 is located, and the acute angle β0 may be consistent with the second acute angle β2 formed by the second slope 30K0 and the plane in which the substrate 10 is located, so that the second slope 30K0 of the third opening 30K and the slope of the fourth opening 70K in the frame area NA may be a continuous inclined surface, which may facilitate the metal layer (such as the first conductive layer 40) on the surface of the first planarization layer 30 and the metal layer on the surface of the third planarization layer 70 to form a bonding pad LP and other structures at the overlapping openings in the frame area NA.

In some other embodiments, as shown in FIG. 29, the acute angle β0 formed by the inclined surface of the fourth opening 70K in the frame area NA and the plane in which the substrate 10 is located may be inconsistent with the second acute angle β2 formed by the second inclined surface 30K0 and the plane in which the substrate 10 is located, and the second acute angle β2 may be slightly larger than the acute angle β0 formed by the inclined surface of the fourth opening 70K in the frame area NA and the plane in which the substrate 10 is located. That is, the slope of the fourth opening 70K of the third planarization layer 70 in the frame area NA may be smoother, so as to further reduce the probability of the metal layer remaining at the fourth opening 70K, thereby better improving the process yield and display quality.

In one embodiment, as shown in FIG. 26 and FIG. 29, the display panel 000 may include a third inclined plane 50K01 in the non-frame area AA. The third inclined plane 50K01 may form a third acute angle β3 with the plane in which the substrate 10 is located. The third acute angle β3 may be smaller than the first acute angle β1.

This embodiment explains that among the plurality of first openings 50K formed in the second planarization layer 50 of the display panel 000, the first opening 50K in the frame area NA may be used to expose structures such as the bonding pad LP, and the first opening 50K in the non-frame area AA may be used to include an electrode 401, so as to bond the light-emitting device 60 through the electrode 401. The slope of the first opening 50K in the frame area NA may be different from the slope of the first opening 50K in the non-frame area AA. Specifically, in the non-frame area AA, the first opening 50K may include a third inclined plane 50K01, and the third inclined plane 50K01 may form a third acute angle β3 with the plane in which the substrate 10 is located; in the frame area NA, the first opening 50K may include a first inclined plane 50K0, and the first inclined plane 50K0 may form a first acute angle β1 with the plane in which the substrate 10 is located. The third acute angle β3 may be smaller than the first acute angle β1, that is, the slope of the first opening 50K in the non-frame area AA may be more gentle, which may be beneficial to the leveling of the ink in the non-frame area AA during the ink packaging, ensuring the packaging effect of the display panel 000 in the non-frame area AA, and improving the display quality and packaging reliability.

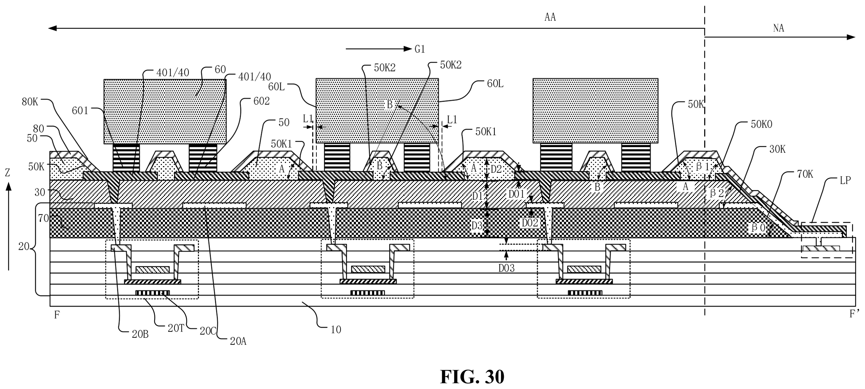

FIG. 30 illustrates a schematic diagram of an F-F'-sectional view in FIG. 26. As shown in FIG. 26 and FIG. 30, in some embodiments, taking a light-emitting device 60 electrically connected to two electrodes 401 as an example, in the two electrodes 401 electrically connected to a light-emitting device 60, along the direction from one electrode 401 to the other electrode 401 (the direction G1 shown in FIG. 30), in the non-frame area AA of the display panel 000, the first opening 50K may include a first slope 50K1 close to the edge 60L of the light-emitting device 60 and a second slope 50K2 away from the edge 60L of the light-emitting device 60. The angle formed between the first slope 50K1 and the plane in which the substrate 10 is located may be an acute angle A, and the angle formed between the second slope 50K2 and the plane in which the substrate 10 is located may be an acute angle B.

In the frame area NA of the display panel 000, the first opening 50K may include a first inclined surface 50K0, and the third opening 30K may include a second inclined surface 30K0. The first inclined surface 50K0 may form a first acute angle β1 with the plane in which the substrate 10 is located, and the second inclined surface 30K0 may form a second acute angle β2 with the plane in which the substrate 10 is located. The inclined surface of the fourth opening 70K in the frame area NA may form an acute angle β0 with the plane in which the substrate 10 is located.

In one embodiment, the acute angle A and the acute angle B of the non-frame area AA may be be equal, the first acute angle β1 of the frame area NA may be greater than the second acute angle β2, and the second acute angle β2 of the frame area NA may be equal to or slightly greater than the acute angle β0 (as described in the above embodiment, the effect of this embodiment is not repeated here). For the second planarization layer 50, the acute angle A and the acute angle B of the non-frame area AA may be smaller than the first acute angle β1 of the frame area NA regardless of whether the angles are the same, so that the slope of the first opening 50K of the non-frame area AA may be more gentle, which may be conducive to improving the leveling of the ink during packaging and ensuring the packaging effect.

In one embodiment, the acute angle A and the acute angle B of the non-frame area AA may be unequal, and the acute angle A of the non-frame area AA may be smaller than the acute angle B, that is, in a first opening 50K corresponding to the light-emitting device 60, the first slope 50K1 of the outer first opening 50K may be more gentle, and the second slope 50K2 of the inner first opening 50K may be slightly steeper, thereby ensuring that the ink may have better leveling in the peripheral area of the light-emitting device 60 during subsequent ink packaging, thereby improving the packaging effect. The first acute angle β1 of the frame area NA may be greater than the second acute angle β2, and the second acute angle β2 of the frame area NA may be equal to or slightly greater than the acute angle β0 (as described in the above embodiment, the effect is not repeated in this embodiment). In this embodiment, for the second planarization layer 50, the acute angles A and B of the non-frame area AA may be smaller than the first acute angle β1 of the frame area NA regardless of whether the angles are the same, so that the slope of the first opening 50K of the non-frame area AA may be more gentle, which may be conducive to improving the leveling of the ink during packaging and ensuring the packaging effect.

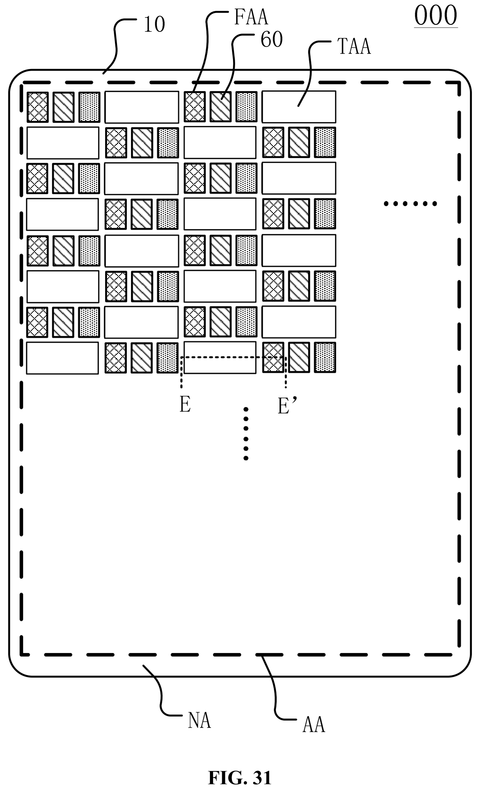

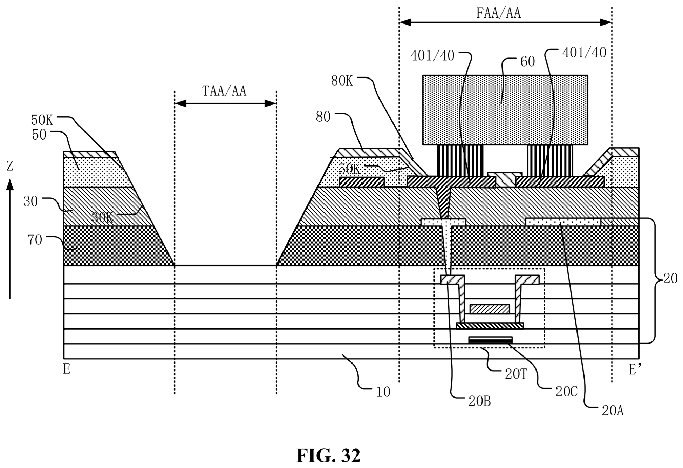

FIG. 31 illustrates a schematic diagram of the planar structure of another exemplary display panel provided in one embodiment of the present disclosure, and FIG. 32 illustrates a schematic diagram of an E-E'-sectional view in FIG. 31. As shown in FIGS. 31-32, in one embodiment, the display panel 000 may include a frame area NA and a non-frame area AA, and the frame area NA may be arranged at least partially around the non-frame area AA. The frame area NA may be understood as the edge area of the display panel 000, and the non-frame area AA may be understood as the area at least partially surrounded by the frame area NA, and may also be understood as the light-emitting or display area of the display panel 000.

In one embodiment, the plurality of first openings 50K of the second planarization layer 50 may pass through the thickness of the second planarization layer 50. Among the plurality first openings 50K, a portion of the first openings 50K may be located in the frame area of the display panel 000, and a portion of the first openings 50K may be located in the non-frame area AA. The portion of the first opening 50K located in the non-frame area AA may be used to expose the electrode 401 to bond the light-emitting device 60. It may also include other first openings 50K that directly pass through the thickness of the second planarization layer 50, which may be equivalent to hollowing out the second planarization layer 50 at the position of the first opening 50K for the transparent display. For example, the non-frame area AA of the display panel 000 may include a light-transmitting area TAA and a light-emitting area FAA (it can be understood that FIG. 31 of this embodiment is only an exemplary drawing of the arrangement of the light-transmitting area TAA and the light-emitting area FAA. In specific implementation, the arrangement and number of the two include but are not limited to this. This embodiment is only an example. The display panel 000 may include a plurality of light-emitting devices 60, and the light-emitting devices 60 may be located in the light-emitting area FAA. A portion of the first openings 50K in the non-frame area AA may be used to expose the electrode 401 to bond the light-emitting device 60, and a portion of the first openings 50K in the non-frame area AA are used to hollow out to form the light-transmitting area TAA to transmit light and realize the transparent display.

The first planarization layer 30 of the first conductive layer 40 of the display panel 000 facing the substrate 10 may also include a plurality of third openings 30K, and the third openings 30K located in the non-frame area AA may be located in the light-transmitting area TAA. The orthographic projection of the third opening 30K on the substrate 10 may overlap with the orthographic projection of the first opening 50K on the substrate 10, or the first opening 50K may expose the third opening 30K, which may be used to hollow out the first planarization layer 30 to form a light-transmitting area TAA to achieve the transparent display.

It can be understood that when the film structure of the display panel 000 includes other organic layers, the light-transmitting area TAA may also be hollowed out to form an opening to ensure the transmittance of the light-transmitting area TAA, thereby achieving a transparent display effect of the display panel 000.

It should be noted that the film structure of the light-transmitting area TAA of the non-frame area AA is not described in detail in this embodiment. In the related art, the area where the first opening 50K is formed in the second planarization layer 50 and the third opening 30K is formed in the first planarization layer 30 of the light-transmitting area TAA of the display panel 000 can be filled with transparent insulating material to ensure the flatness of the entire panel. This embodiment is not described in detail here, and the specific understanding can be referred to the film structure of the transparent display panel.

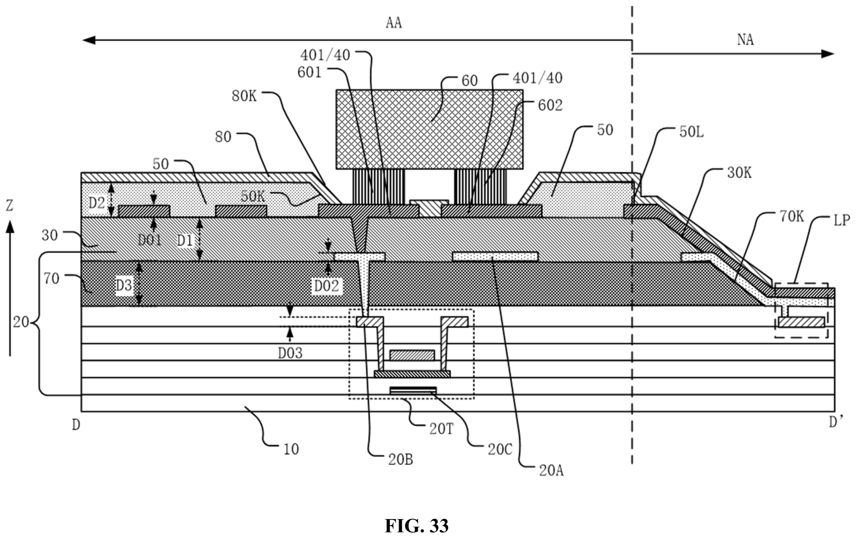

FIG. 33 illustrates another D-D'-sectional view in FIG. 26. As shown in FIG. 26 and FIG. 33, in some embodiments, the second planarization layer 50 is not located in the frame area, and a first frame opening 50L in the frame area NA comprises a space located at a same level as the second planarization layer 50.

This embodiment explains that the frame area NA of the display panel 000 may not be provided with the second planarization layer 50, that is, the second planarization layer 50 may be level with the first frame opening 50L in the frame area NA. The first frame opening 50L may be formed by removing a layer corresponding to the second planarization layer 50 from the frame area NA. In some embodiments, the first frame opening 50L is provided such that the frame area NA not have the second planarization layer 50. The display panel 000 of this embodiment may be a spliced display panel. In order to realize the splicing of different display panels 000, and then realize the splicing display of at least two display panels 000, the frame area NA of the display panel 000 may need to be cut and edge grinded. Because the organic film layer may affect the laser transmission of the cutting and edge grinding process, carbonization may cause surrounding pollution, and the organic film layer may also cause the problem of peeling of the organic layer at the edge grinding. Therefore, in this embodiment, the second planarization layer 50 does not exist in the frame area NA through setting the first frame opening 50L in the frame area NA, thereby avoiding the existence of the organic layer in the frame area NA affecting the cutting and edge grinding process of the panel, and ensuring the adhesion of the film layer of the display panel 000 in the frame area NA, which may be conducive to improving the splicing effect of the display panel 000 when being used for splicing display.

It can be understood that the first frame opening 50L of the second planarization layer 50 of this embodiment may be set at least in the frame area NA on one side edge of the display panel 000, or in the two frame areas NA on the opposite sides of the display panel 000, or in the four frame areas NA around the display panel 000, so as to achieve the display panel 000 as a sub-board of the splicing panel, when the sub-board is cut and edged, the organic film layer material may affect the laser transmission of the cutting and edge grinding process, and ensure the process technology.

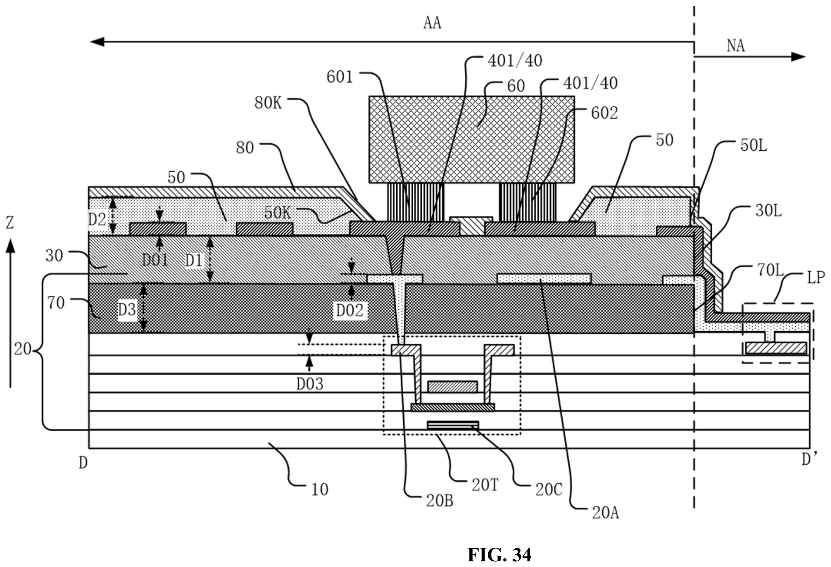

FIG. 34 is a schematic diagram of another D-D'-sectional view in FIG. 26. As shown in FIG. 26 and FIG. 34, when the display panel 000 in this embodiment includes other organic film layers such as a first planarization layer 30 and a third planarization layer 70, the first planarization layer 30 may be level with a second frame opening 30L in the frame area NA, and the third planarization layer 70 may be level with a third frame opening 70L in the frame area NA. The two organic film layers may be removed from the frame area NA to ensure that there is no organic material in the frame area NA affecting the laser cutting and edge grinding process.

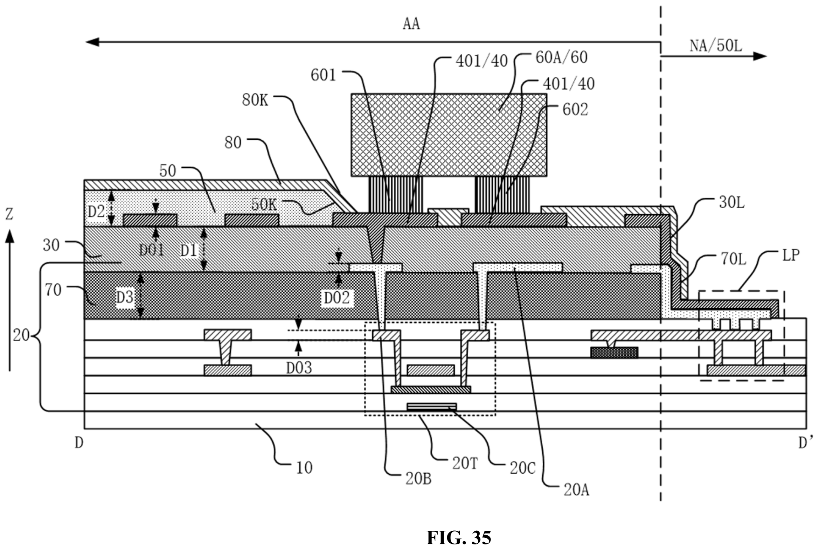

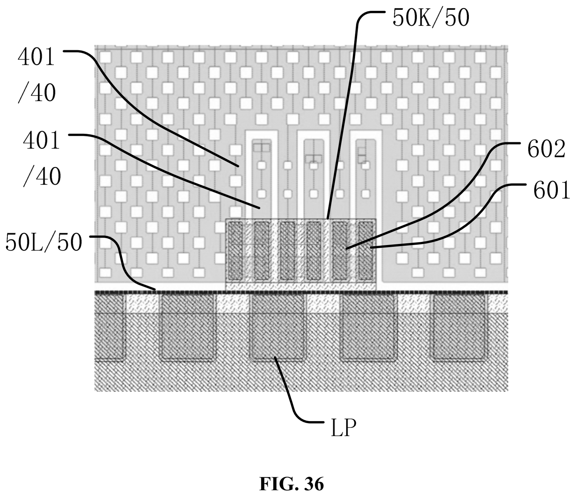

FIG. 35 illustrates a structural schematic diagram of another D-D'-sectional view in FIG. 26, and FIG. 36 is a partial planar structural schematic diagram of the J3 area in FIG. 26 (it can be understood that in order to clearly illustrate the structure of the display panel, FIG. 36 is filled with transparency). As shown in FIG. 26 and FIG. 35, in some embodiments, the non-frame area AA may include a plurality of light-emitting devices 60. The light-emitting devices 60 may be electrically connected to the driving array layer 20 through the electrodes 401.

The light-emitting device 60 may include a first light-emitting device 60A, and no light-emitting device 60 may be located between the first light-emitting device 60A and the nearest portion (i.e., a portion nearest to the first light-emitting device 60A) of the frame area NA. That is, the first light-emitting device 60A may be one of the "edge" light-emitting devices (i.e., the light-emitting devices from an edge of the plurality of the light-emitting devices) close to the frame area NA among the plurality of light-emitting devices 60 included in the non-frame area AA. The first opening 50K corresponding to the first light-emitting device 60A may be connected to the first frame opening 50L.

This embodiment explains that the display panel 000 may be used in a spliced display panel. To minimize the frame of the display panel at the splicing position or even to achieve a frame-less display panel, it may be necessary to remove the organic material layer at an edge-grinding region of the frame area NA around the display panel 000, such that a boundary for performing edge-cutting and edge-grinding is exposed to meet the process requirements. At this time, when the first frame opening 50L of the frame area NA is close to the first light-emitting device 60A in the non-frame area AA, if the design space is insufficient, that is, the first light-emitting device 60A is very close to the first frame opening 50L, the first opening 50K corresponding to the first light-emitting device 60A may be connected to the first frame opening 50L. In this way, the connection area of the second planarization layer 50 between the first opening 50K and the first frame opening 50L at the cutting and grinding position may be eliminated, which may be conducive to using the display panel 000 of this embodiment to achieve a frame-less spliced panel design.

It can be understood that FIG. 36 of this embodiment only takes a first opening 50K, which exposes the electrodes 401 electrically connected to three adjacent light-emitting devices 60 of different colors, in the non-frame area AA as an example for illustration. The setting mode of the first opening 50K in the non-frame area AA may also be other setting modes. The specific understanding may be referred to the above embodiments, and this embodiment will not be repeated here.

As shown in FIG. 35, the bonding pad LP of the frame area NA in this embodiment may be formed by a conductive structure provided by multiple metal conductive layers through multiple vias, so as to realize the transmission of the driving signal provided by the bonding pad LP to the non-frame area AA of the display panel 000 through multiple metal layers at different positions, so as to achieve the effect of transmitting the driving signal and realizing the panel driving display. FIG. 35 of this embodiment is only an example of a setting structure of the bonding pad LP. When it is implemented, the setting mode of the bonding pad LP of the frame area NA may include but is not limited to this, and may also include other setting modes, which are not limited in this embodiment.

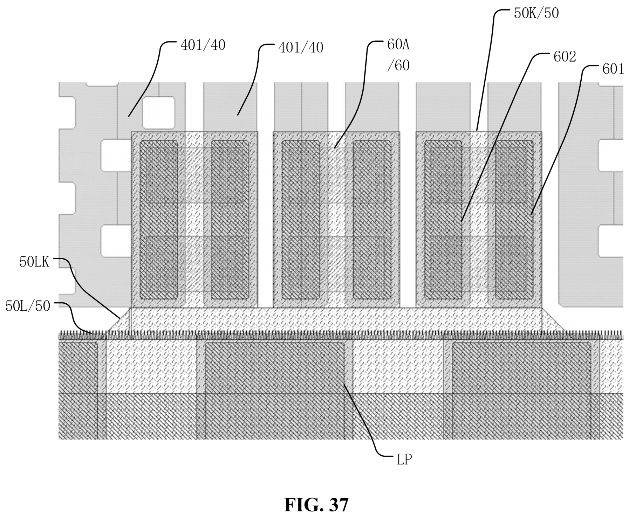

FIG. 37 is another partial planar structural schematic diagram of the J3 region in FIG. 26 (it can be understood that, in order to clearly illustrate the structure of the display panel, FIG. 37 is filled with transparency). As shown in FIG. 26 and FIG. 37, in one embodiment, the second planarization layer 50 may be further leveled with a transition opening 50LK. The first opening 50K exposing the electrode(s) 401 electrically connected to the first light-emitting device 60A may be spatially connected to the first frame opening 50L through the transition opening 50LK, and the edge of the positive projection of the transition opening 50LK on the substrate 10 may be arc-shaped.

This embodiment explains that the first frame opening 50L of the frame area NA may be located adjacent to the first light-emitting device 60A in the non-frame area AA, and the first opening 50K corresponding to the first light-emitting device 60A may be connected to the first frame opening 50L. In this way, the connection area of the second planarization layer 50 between the first opening 50K and the first frame opening 50L at the cutting and grinding position may be eliminated, which may be conducive to realizing a frameless splicing panel design. In this embodiment, the first opening 50K corresponding to the first light-emitting device 60A may be further arranged to be connected to the first frame opening 50L through a transition opening 50LK. The edge of the transition opening 50L on the positive projection of the substrate 10 may be an arc shape or other smooth shape for transition, which may be conducive to improving the implementation effect of the subsequent packaging process.

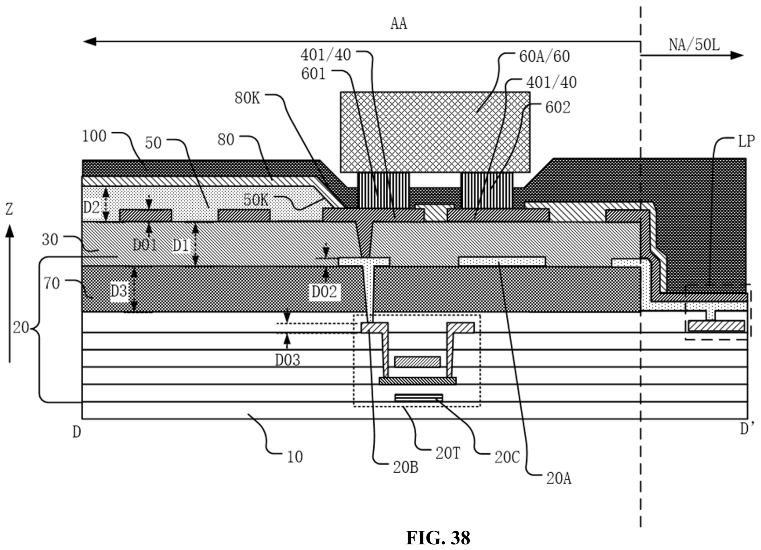

FIG. 38 illustrates another D-D'-sectional view in FIG. 26. As shown in FIG. 26 and FIG. 38, in one embodiment, the display panel 000 may also include an ink encapsulation layer 100. The ink encapsulation layer 100 may be located on the side of the first passivation layer 80 away from the substrate 10. The ink encapsulation layer 100 may be filled between adjacent light-emitting devices 60. The light-emitting surface of the light-emitting device 60 may need to be exposed. The ink encapsulation layer 100 may reduce the reflection of the display panel 000 to the ambient light, play a role in reducing reflection, and may also avoid color crosstalk between adjacent light-emitting devices 60. The edges of the first frame opening 50L and the transition opening 50LK of the second planarization layer 50 in the orthographic projection of the substrate 10 may be set to be smooth, which may ensure the implementation effect of the subsequent ink encapsulation process, and may also ensure that the organic film layer in the frame area NA is hollowed out, so as to be suitable for the splicing panel and ensure the process yield.

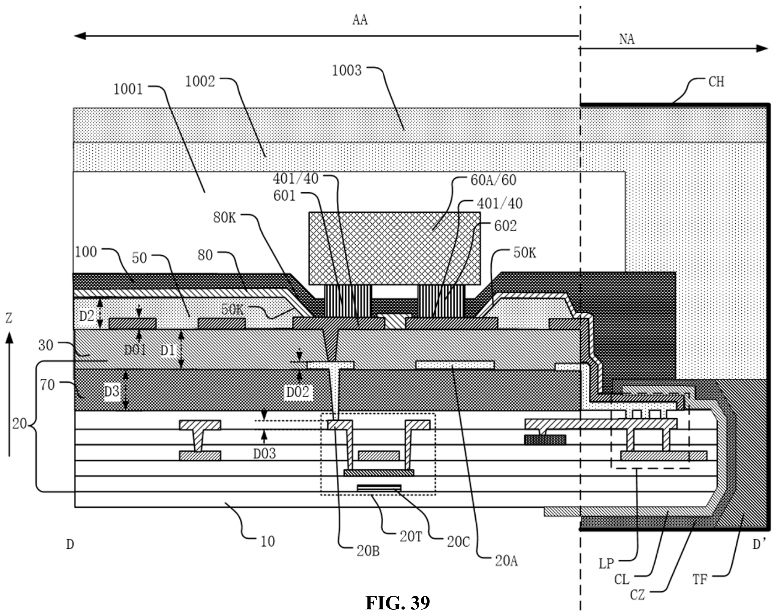

FIG. 39 is another D-D'-sectional view in FIG. 26. As shown in FIG. 26 and FIG. 39, in one embodiment, the display panel 000 may be applied to a frameless splicing display device, that is, the frame area NA of the display panel 000 may be reduced as much as possible, or even frameless. For example, the side wiring of the frame area NA may be used to pull the wire to the backlight side of the display panel 000 (the side of the substrate 10 away from the drive array layer 20), and the bonding pad LP on the light-exiting side of the display panel 000 may be pulled to the pad on the backlight side of the display panel 000 (not shown in FIG. 39) through the side wiring, so as to achieve the bonding of the driver chip or the flexible circuit board on the backlight side of the display panel 000.

Specifically, as shown in FIG. 39, the bonding pad LP may be pulled to the side of the substrate 10 away from the driving array layer 20 through the side wiring CL, which may be equivalent to setting the bonding area of the display panel on the backlight side of the display panel. In this way, the bonding area may not need to occupy the space on the front of the display panel 000, which may be conducive to realizing the extremely narrow frame or frameless design of the display panel and meeting the splicing requirements of large-size display products.

Further, the side wiring CL of this embodiment may be covered with a side wiring encapsulation layer CZ, which may be a high-resistance ink, used to protect the side wiring CL, prevent the side wiring CL from being affected by external moisture, oxygen, etc., and corrosion and other problems, affecting the reliability of signal transmission on the side wiring CL. The side wiring encapsulation layer CZ may be a black or gray light-shielding material, which may avoid or reduce the problem of light leakage on the side of the display panel 000.

In one embodiment, the side wiring encapsulation layer CZ may be filled with a filling encapsulation member TF with high buffering performance, and the filling encapsulation member TF may at least partially cover the side wiring encapsulation layer CZ. It can be understood that the side wiring encapsulation layer CZ may be further coated with the filling encapsulation member TF. Through the double encapsulation of the filling encapsulation member TF and the side wiring encapsulation layer CZ, it may be more conducive to improving the encapsulation reliability of the side edge of the display panel 000. In one embodiment, the filling encapsulation member TF may also be a black or gray material with a light-absorbing effect.

In one embodiment, the ink encapsulation layer 100 of the display panel 000 may include a transparent encapsulation layer 1001 and a composite film material 1003 bonded by a glue layer 1002 in sequence on the side away from the substrate 10. The transparent encapsulation layer 1001 and the glue layer 1002 may also be replaced by a transparent glue layer, which may encapsulate the front of the light-emitting device 60 to prevent the external moisture and oxygen from affecting the light-emitting device 60. At the same time, the surface of the transparent encapsulation layer 1001 away from the substrate 10 may be a flat surface, and the composite film material 1003 may be adhered as a protective layer through the glue layer 1002. For example, the composite film material 1003 may be a transparent cover plate.

In one embodiment, a side blackening layer CH may be provided at the outermost portion of the frame area NA of the display panel 000. The side blackening layer CH may be a black material or a material with high light absorption or high grayscale. In this way, the side blackening layer CH may prevent the light from leaking sideways from the display panel. The side blackening layer CH may also be used as an encapsulation layer to improve the encapsulation reliability of the display panel, and as the first line of defense to prevent moisture and oxygen from entering the lateral direction of the display panel. As shown in FIG. 39, the side blackening layer CH may extend from the side to the frame area of the front, side and back of the display panel, which may realize the lateral encapsulation of the display panel and block the lateral light leakage.

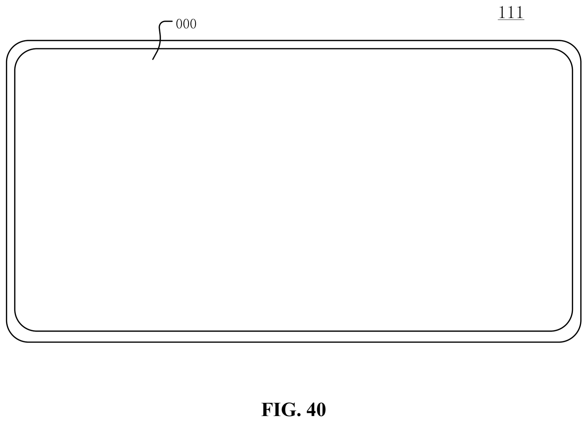

The present disclosure also provides a display device. FIG. 40 illustrates a schematic diagram of a top view of an exemplary display device provided in one embodiment of the present disclosure. As shown in FIG. 40, the display device 111 provided in this embodiment may include a display panel 000 provided in the above embodiments of the present disclosure. The display device 000 of this embodiment may be a transparent display device, or may be a spliced display device including a plurality of display panels 000 in the above embodiments, which is not limited in this embodiment. The display device 000 of this embodiment may be a large-sized spliced display device, such as a large-screen display device for public display. In another embodiment, the spliced display device of this embodiment may be a display device spliced by the display panels 000 with no frame or extremely narrow frame of the embodiment of FIG. 39. The display device 111 provided in the embodiment of the present disclosure may have the beneficial effects of the display panel 000 provided in the embodiment of the present disclosure. For details, reference may be made to the specific description of the display panel 000 in the above embodiments, which will not be repeated in this embodiment.

Accordingly, the display panel provided by the present disclosure may further set a second planarization layer on the side of the patterned first conductive layer away from the substrate. The material of the second planarization layer may be the same as that of the first planarization layer, that is, the second planarization layer may be an organic film layer to flatten the surface of the first conductive layer away from the substrate, so that the surface of the patterned first conductive layer may be covered by the second planarization layer of organic material, which may play a role in flattening the surface of the first conductive layer. That is, a large number of concave-convex structures presented by the patterned first conductive layer can be flattened by the second planarization layer, which may improve the flatness problem of the substrate and may be conducive to improving the performance of the substrate and the display effect. The second planarization layer of the present disclosure may include a plurality of first openings, the first openings may pass through the second planarization layer, and in the direction perpendicular to the plane in which the substrate is located, the first openings may expose at least a portion of the electrodes, so as to facilitate the subsequent light-emitting device to be bonded to the electrode in the first opening. The present disclosure may set the second planarization layer on the side of the first conductive layer away from the substrate. Through the high flatness performance of the second planarization layer, the flatness problem of the substrate may be improved, the performance of the substrate may be guaranteed, and the display effect may be improved.

It should be noted that, in this disclosure, relational terms, such as "first" and "second", etc., are only used to distinguish one entity or operation from another entity or operation, and do not necessarily require or imply any such actual relationship or order between these entities or operations. Moreover, the terms "include", "comprise" or any other variant thereof are intended to cover non-exclusive inclusion, so that a process, method, article or device including a series of elements includes not only those elements, but also other elements not explicitly listed, or also includes elements inherent to such a process, method, article or device. In the absence of further restrictions, an element defined by the sentence "comprising a ..." does not exclude the presence of other identical elements in the process, method, article or device comprising the element.

The above is only a specific implementation of the present disclosure, so that those skilled in the art can understand or implement the present disclosure.

**Claims**

1. A display panel, comprising:

   a substrate;
   a driving array layer located on a side of the substrate;
   a first planarization layer located on a side of the driving array layer away from the substrate;
   a first conductive layer located on a side of the first planarization layer away from the substrate, wherein the first conductive layer comprises a plurality of electrodes; and
   a second planarization layer located a side of the first conductive layer away from the substrate, wherein the second planarization layer comprises a plurality of first openings running through the second planarization layer;
   wherein in a direction perpendicular to a first plane in which the substrate is located, a first opening of the plurality of first openings exposes at least a portion of an electrode of the plurality of electrodes.

2. The display panel according to claim 1, wherein in the direction perpendicular to the first plane,

   a thickness of the second planarization layer is less than a thickness of the first planarization layer, and
   the thickness of the second planarization layer is greater than a thickness of the first conductive layer.

3. The display panel according to claim 2, wherein:

   the thickness of the first planarization layer is D1;
   the thickness of the second planarization layer is D2; and

   $$1/2D1 < D2 < 4/5D1.$$

4. The display panel according to claim 2 or 3, further comprising:

   a second conductive layer located on a side of the first planarization layer facing the substrate, wherein in the direction perpendicular to the first plane, a thickness of the second conductive layer is less than the thickness of the first conductive layer.

5. The display panel according to any one of claims 1 to 4, further comprising:
   a first passivation layer located on a side of the second planarization layer away from the substrate, wherein:

   the first passivation layer comprises a plurality of second openings,
   an orthographic projection of a second opening of the plurality of second openings on the substrate is located within an orthographic projection of the first opening on the substrate;
   at a periphery of the first opening, the second planarization layer covers at least a portion of the electrode in the direction perpendicular to the first plane; and
   at a periphery of the second opening, the first passivation layer covers the second planarization layer in the direction perpendicular to the first plane.

**6.** The display panel according to claim 5, wherein: the plurality of electrodes is located on a surface of the first planarization layer, and the second planarization layer is in direct contact with at least a part of the surface of the first planarization layer.

**7.** The display panel according to claim 5 or 6, wherein: in the direction perpendicular to the first plane, a quantity of electrodes among the plurality of electrodes exposed by the first opening is one, and a quantity of electrodes among the plurality of electrodes exposed by the second opening is one.

**8.** The display panel according to claim 7, further comprising:

a plurality of light-emitting devices, wherein:

a light-emitting device of the plurality of light-emitting devices is electrically connected to at least two electrodes of the plurality of electrodes; the light-emitting device is electrically connected to the driving array layer via the at least two electrodes; the first opening exposes at least one of the at least two electrodes; an edge of the first opening comprises a first slope and a second slope, the first slope is located at a part of the edge away from a center the light-emitting device, and the second slope is located at a part of the edge close to the center of the light-emitting device; and a first acute angle included between the first slope and the first plane is smaller than a second acute angle included between the second slope and the first plane.

**9.** The display panel according to claim 5 or 6, further comprising:

a plurality of light-emitting devices, wherein:

a light-emitting device of the plurality of light-emitting devices is electrically connected to at least two electrodes of the plurality of electrodes; the light-emitting device is electrically connected to the driving array layer via the at least two electrodes; and in the direction perpendicular to the first plane, the first opening exposes the at least two electrodes.

**10.** The display panel according to claim 9, wherein:

in the direction perpendicular to the first plane, a quantity of electrodes among the plurality of electrodes exposed by the second opening is one; the at least two electrodes comprise the electrode; and the first passivation layer covers the first planarization layer located between the electrode and another electrode of the at least two electrodes, and the first passivation layer covers another portion of the electrode.

**11.** The display panel according to claim 9 or 10, wherein;

the electrode is a first electrode, and the light-emitting device is electrically connected to the first electrode and a second electrode of the at least two electrodes; each of the first electrode and the second electrode comprises a first region and a second region; the first opening comprises a first sub-opening and a second sub-opening; and in the direction perpendicular to the first plane, the first sub-opening exposes the first region of the first electrode and the first region of the second electrode, and the second sub-opening exposes the second region of the first electrode and the second region of the second electrode.

**12.** The display panel according to claim 11, wherein:

the first conductive layer comprises a plurality of through holes; an orthographic projection of the plurality of through holes on the substrate does not overlap with an orthographic projection of the first regions and the second regions, of the first electrode and the second electrode, on the substrate.

**13.** The display panel according to any one of claims 5 to 7, further comprising:

a plurality of light-emitting devices electrically connected to the driving array layer via the plurality of electrodes, wherein three adjacent light-emitting devices of different colors, among the plurality of light-emitting devices, are electrically connected to the electrodes exposed by the first opening.

**14.** The display panel according to claim 13, wherein:

in the direction perpendicular to the first plane, a quantity of electrodes among the plurality of electrodes exposed by the second opening is one; and
one of the three adjacent light-emitting devices is electrically connected to the electrode and another electrode of the plurality of electrodes; the first passivation layer covers the first planarization layer located between the electrode and the another electrode, and the first passivation layer covers another portion of the electrode.

15. The display panel according to any one of claims 1 to 4, further comprising:

a first passivation layer located between the second planarization layer and the first conductive layer,
wherein:

the first passivation layer comprises a plurality of second openings;
an orthographic projection of a second opening of the plurality of second openings on the substrate overlaps with an orthographic projection of the electrode of the plurality of electrodes on the substrate; and
at a periphery of the second opening, the first passivation layer covers at least a portion of the electrode in the direction perpendicular to the first plane.

16. The display panel according to any one of claims 5 to 7, further comprising:

a third conductive layer comprising a plurality of gap fills,
wherein:

a gap fill of the plurality of gap fills is in direct contact with the electrode and an orthographic projection of the gap fill on the substrate partially overlaps with an orthographic projection of the electrode on the substrate; and
the display panel further comprises a plurality of light-emitting devices electrically connected to the driving array layer via the plurality of electrodes and the plurality of gap fills.

17. The display panel according to claim 16, wherein: along the direction perpendicular to the first plane, a first surface of the gap fill away from the electrode and a second surface of the second planarization layer away from the substrate are parallel to the first plane are separated by a distance ranging from 0.1um to 2um.

18. The display panel according to claim 16 or 17, wherein:

the third conductive layer is located on a side of the first passivation layer away from the substrate, or the third conductive layer is located between the first passivation layer and the second planarization layer; and
the orthographic projection of the gap fill on the substrate is located within an orthographic projection of the electrode on the substrate.

19. The display panel according to claim 16 or 17, wherein:

the third conductive layer is located between the first passivation layer and the second planarization layer; and
the orthographic projection of the gap fill on the substrate covers an orthographic projection of the electrode on the substrate.

20. The display panel according to any one of claims 1 to 7 and 15, wherein:

the first planarization layer comprises a plurality of third openings; and
an orthographic projection of a third opening of the plurality of third openings on the substrate overlap with an orthographic projection of the first opening on the substrate.

21. The display panel according to claim 20, comprising:

a frame area and a non-frame area,
wherein:

the frame area at least partially surrounds the non-frame area; and
in the frame area, the first opening exposes the third opening.

22. The display panel according to claim 21, wherein:

in the frame area, an edge of the first opening comprises a first inclined surface, and an edge of the third opening comprises a second inclined surface; and
a first acute angle included between the first inclined surface and the first plane is greater than a second acute angle included between the second inclined surface and the first plane.

23. The display panel according to claim 22, wherein:

in the non-frame area, the edge of the first opening comprises a third inclined surface; and
a third acute angle included between the third inclined surface and the first plane is smaller than the first acute angle.

24. The display panel according to any one of claims 21 to 23, wherein:

> the display panel comprises a plurality of light-emitting devices located in the non-frame area; the non-frame area comprises a light-transmitting area and a light-emitting area; the plurality of light-emitting devices is located in the light-emitting area; and an orthographic projection of the plurality of third openings on the substrate is located in the light-transmitting area.

25. The display panel according to any one of claims 21 to 24, wherein:

> the second planarization layer is not located in the frame area, and a first frame opening in the frame area comprises a space located at a same level as the second planarization layer.

26. The display panel according to claim 25, wherein:

> a plurality of light-emitting devices is located in the non-frame area and is connected to the driving array layer via the plurality of electrodes; a first light-emitting device is an edge light-emitting device of the plurality of light-emitting devices; the first light-emitting device is electrically connected to the electrode exposed by the first opening; and the first opening is spatially connected to the first frame opening.

27. The display panel according to claim 26, wherein:

> the first opening is spatially connected to the first frame opening via a transition opening; and an edge of an orthographic projection of the transition opening on the substrate of is arc-shaped.

28. A display device, comprising a display panel according to any one of claims 1 to 27.

**FIG. 1**

**FIG. 2**

**FIG. 3**

**FIG. 4**

**FIG. 5**

**FIG. 6**

**FIG. 7**

FIG. 8

**FIG. 9**

**FIG. 10**

**FIG. 11**

FIG. 12

000

10  60

J2

**FIG. 13**

50KA/50K

4011/401 /40  4012/401 /40  80K  80K  80K  601  60  602

401A

401B

80K  80K  80K

50KB/50K

**FIG. 14**

**FIG. 15**

**FIG. 16**

37

**FIG. 17**

**FIG. 18**

EP 4 770 359 A1

FIG. 19

**FIG. 20**

**FIG. 21**

**FIG. 22**

**FIG. 23**

**FIG. 24**

**FIG. 25**

**FIG. 26**

**FIG. 27**

EP 4 770 359 A1

FIG. 28

**FIG. 29**

FIG. 30

**FIG. 31**

**FIG. 32**

EP 4 770 359 A1

**FIG. 33**

**FIG. 34**

EP 4 770 359 A1

**FIG. 35**

EP 4 770 359 A1

**FIG. 36**

**FIG. 37**

FIG. 38

FIG. 39

111

000

**FIG. 40**

Europäisches
Patentamt

European
Patent Office

Office européen
des brevets

# EUROPEAN SEARCH REPORT

**Application Number**

EP 25 21 7507

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/237954 A1 (LEE K ET AL) 27 July 2023 (2023-07-27) | 1,5-7, 9-14,28 | INV. H10H29/39 H10H29/41 |
| A | * paragraphs [0345] - [0491] * | 16-19 | |
| X | WO 2024/221399 A1 (BOE TECHNOLOGY ET AL) 31 October 2024 (2024-10-31) | 1,5, 7-14,28 | |
| A | * page 11, line 4 - page 24, line 27 * | 20 | |
| X | EP 4 451 334 A1 (LG ELECTRONICS; LG DISPLAY) 23 October 2024 (2024-10-23) | 1-4,28 | |
| A | * paragraphs [0060] - [0160] * | 5,20 | |
| X | US 2024/038737 A1 (AN F ET AL) 1 February 2024 (2024-02-01) | 1,20,21, 24-28 | |
| A | * paragraphs [0057] - [0135] * | 5,22,23 | |
| X | WO 2024/197852 A1 (BOE TECHNOLOGY) 3 October 2024 (2024-10-03) * page 12, line 9 - page 13, line 17 * | 1,15,28 | |

**TECHNICAL FIELDS SEARCHED (IPC)**

H10H

The present search report has been drawn up for all claims

| Place of search | Date of completion of the search | Examiner |
|---|---|---|
| The Hague | 8 April 2026 | van der Linden, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 7507

This annex lists the patent family members relating to the patent documents cited in the above-mentioned European search report.
The members are as contained in the European Patent Office EDP file on
The European Patent Office is in no way liable for these particulars which are merely given for the purpose of information.

08-04-2026

| Patent document cited in search report | Publication date | Patent family member(s) | Publication date |
|---|---|---|---|
| US 2023237954 A1 | 27-07-2023 | CN 116487407 A | 25-07-2023 |
| | | CN 219834823 U | 13-10-2023 |
| | | EP 4216277 A1 | 26-07-2023 |
| | | KR 20230113452 A | 31-07-2023 |
| | | TW 202336728 A | 16-09-2023 |
| | | US 2023237954 A1 | 27-07-2023 |
| WO 2024221399 A1 | 31-10-2024 | CN 119234313 A | 31-12-2024 |
| | | EP 4593081 A1 | 30-07-2025 |
| | | TW 202443545 A | 01-11-2024 |
| | | US 2025248195 A1 | 31-07-2025 |
| | | WO 2024221399 A1 | 31-10-2024 |
| EP 4451334 A1 | 23-10-2024 | CN 118382931 A | 23-07-2024 |
| | | EP 4451334 A1 | 23-10-2024 |
| | | KR 20240104165 A | 04-07-2024 |
| | | US 2025054923 A1 | 13-02-2025 |
| | | WO 2023113148 A1 | 22-06-2023 |
| US 2024038737 A1 | 01-02-2024 | CN 116564949 A | 08-08-2023 |
| | | US 2024038737 A1 | 01-02-2024 |
| WO 2024197852 A1 | 03-10-2024 | CN 119072772 A | 03-12-2024 |
| | | US 2025280640 A1 | 04-09-2025 |
| | | WO 2024197852 A1 | 03-10-2024 |

EPO FORM P0459

For more details about this annex : see Official Journal of the European Patent Office, No. 12/82